# EUROPEAN PATENT APPLICATION

(11) **EP 4 793 934 A1**
(43) Date of publication of application: **19.08.2026**
(21) Application number: 26157901.5
(22) Date of filing: 11.02.2026
(51) Int. Cl.: G09G 3/3233

(54) **DISPLAY DEVICE AND ELECTRONIC DEVICE INCLUDING THE SAME**

(30) Priority: 13.02.2025 KR 20250018554
(71) Applicant: Samsung Display Co., Ltd., Yongin-si, Gyeonggi-do 17113 (KR)
(72) Inventor: Kim, Sung Hwan, Yongin-si, Gyeonggi-do (KR); Kim, Dae Hyun, Yongin-si, Gyeonggi-do (KR); Park, Hyun Ae, Yongin-si, Gyeonggi-do (KR); Shin, Hey Jin, Yongin-si, Gyeonggi-do, (KR); Jin, Chang Kyu, Yongin-si, Gyeonggi-do (KR); Kim, Byung Sun, Yongin-si, Gyeonggi-do (KR); Jang, Hwan Soo, Yongin-si, Gyeonggi-do (KR)
(74) Representative: Gulde & Partner

(57) **Abstract**

Provided a display device which comprises a substrate comprising a display area in which emission areas are arranged; a circuit layer located on the substrate; and an element layer located on the circuit layer. The element layer comprises light emitting elements arranged in each of the emission areas. The circuit layer comprises light emitting pixel drivers arranged in a first direction and a second direction and transmitting a driving current to the light emitting elements; a first power main line extending in the first direction and transmitting a first power to the light emitting pixel drivers; and a second power main line extending in the first direction and transmitting a second power different from the first power to some of the light emitting pixel drivers.

## Description

### BACKGROUND

### 1. TECHNICAL FIELD

The present disclosure relates to a display device and an electronic device including the same.

### 2. DESCRIPTION OF THE RELATED ART

With the advance of information-oriented society, more and more demands are placed on display devices for displaying images in various ways. For example, display devices are employed in various electronic devices such as smartphones, digital cameras, laptop computers, navigation devices, and smart televisions.

The display device may be a flat panel display device such as a liquid crystal display device, a field emission display device and a light emitting display device. Examples of the light emitting display device may include an organic light emitting display device including organic light emitting elements, an inorganic light emitting display device including inorganic light emitting elements such as inorganic semiconductors, and a micro light emitting display device including micro light emitting elements.

The organic light emitting display device displays an image using light emitting elements, each including a light emitting layer containing an organic light emitting material. As described above, the organic light emitting display device implements image display using a self-light emitting element, and thus may have relatively superior performance in power consumption, response speed, luminous efficiency, luminance, and wide viewing angle compared to other display devices.

### SUMMARY

When the light emitting elements of the display device have the same structure, the luminance of some colors may be lower than the luminance of some other colors due to the differences in the organic light emitting materials.

The light emitting elements of some colors may include two or more light emitting stacks. In this way, the luminance of the light emitting element of some colors may be increased, thereby improving the display quality of the display device.

Since the light emitting elements of some colors have a different structure from that of the light emitting elements of some other colors, the voltage-current characteristics of the light emitting elements of some colors may differ from those of the light emitting elements of some other colors.

However, when all the light emitting elements are driven by the same power regardless of the differences in the voltage-current characteristics, unnecessary power consumption may occur in the display device.

Aspects of the present disclosure provide a display device capable of reducing power consumption while improving display quality, and an electronic device including the same.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

According to an aspect of the present disclosure, there is provided a display device comprises a substrate comprising a display area in which emission areas are arranged; a circuit layer located on the substrate; and an element layer located on the circuit layer. The element layer comprises light emitting elements arranged in each of the emission areas. The circuit layer comprises light emitting pixel drivers arranged in a first direction and a second direction and transmitting a driving current to the light emitting elements; a first power main line extending in the first direction and transmitting a first power to the light emitting pixel drivers; and a second power main line extending in the first direction and transmitting a second power different from the first power to some of the light emitting pixel drivers.

The emission areas comprise a first emission area, a second emission area, and a third emission area that emit light of different wavelength bands. The light emitting pixel drivers comprise a first light emitting pixel driver electrically connected to a light emitting element of the first emission area; a second light emitting pixel driver electrically connected to a light emitting element of the second emission area; and a third light emitting pixel driver electrically connected to a light emitting element of the third emission area. Each of the light emitting pixel drivers comprises a first transistor generating the driving current; a second transistor electrically connected between a data line that transmits a data signal and a gate electrode of the first transistor; a third transistor electrically connected between a reference voltage line that transmits a reference voltage and the gate electrode of the first transistor; a first capacitor electrically connected between the gate electrode of the first transistor and a first node; a second capacitor electrically connected between the first power main line and the first node; a fourth transistor electrically connected between an initialization voltage line that transmits an initialization voltage and a second node; a fifth transistor electrically connected to a first electrode of the first transistor; and a sixth transistor electrically connected between the first node and the second node. The first node is electrically connected to a second electrode of the first transistor. the second node is electrically connected to one of the light emitting elements. The fifth transistor of the first light emitting pixel driver and the fifth transistor of the second light emitting pixel driver are electrically connected to the first power main line. The fifth transistor of the third light emitting pixel driver is electrically connected to the second power main line.

The circuit layer comprises a first semiconductor layer located on the substrate; a first gate insulating layer covering the first semiconductor layer; a first gate conductive layer located on the first gate insulating layer; a second gate insulating layer covering the first gate conductive layer; a second gate conductive layer located on the second gate insulating layer; a first interlayer insulating layer covering the second gate conductive layer; a second semiconductor layer located on the first interlayer insulating layer; a third gate insulating layer covering the second semiconductor layer; a third gate conductive layer located on the third gate insulating layer; a second interlayer insulating layer covering the third gate conductive layer; a first source-drain conductive layer located on the second interlayer insulating layer; a first planarization layer covering the first source-drain conductive layer; a second source-drain conductive layer located on the first planarization layer; and a second planarization layer covering the second source-drain conductive layer. A channel portion, the first electrode, and the second electrode of the first transistor are located in the second semiconductor layer. A channel portion, a first electrode, and a second electrode of the fifth transistor are located in the first semiconductor layer.

The first transistor comprises a main gate electrode located in the second gate conductive layer, overlapping the channel portion of the first transistor, and electrically connected to the second transistor and the third transistor; and a sub-gate electrode located in the third gate conductive layer, overlapping the channel portion of the first transistor, and electrically connected to the second electrode of the first transistor.

Each of the light emitting pixel drivers comprises a first capacitor electrode located in the first gate conductive layer and electrically connected to the second electrode of the first transistor and the sub-gate electrode; a second capacitor electrode located in the second gate conductive layer and electrically connected to the main gate electrode; and a third capacitor electrode located in the second gate conductive layer, spaced apart from the second capacitor electrode, and electrically connected to the first power main line. The first capacitor is formed by a region where the first capacitor electrode and the second capacitor electrode overlap in the third direction. The second capacitor is formed by a region where the first capacitor electrode and the third capacitor electrode overlap in a third direction.

The first power main line is located in the first source-drain conductive layer The second capacitor is further formed by a region where the sub-gate electrode of the first transistor and the first power main line overlap in the third direction.

Each of the light emitting pixel drivers further comprises a third capacitor electrically connected between an additional power line and the first node. The additional power line transmits one of the first power, the second power, and a third power. The third power is different from the first power and the second power.

The circuit layer further comprises a light blocking conductive layer located on the substrate; and a buffer layer covering the light blocking conductive layer. The first semiconductor layer is located on the buffer layer. The additional power line is located in the light blocking conductive layer. The third capacitor is formed by a region where the first capacitor electrode and the additional power line overlap in the third direction.

The first power main line is located in the first source-drain conductive layer. The second power main line is located in the third gate conductive layer. The circuit layer further comprises a first power sub-line located in the second source-drain conductive layer, extending in the second direction, and electrically connected to the first power main line; and a second power sub-line located in the second source-drain conductive layer, extending in the second direction, and electrically connected to the second power main line.

Each of the light emitting pixel drivers intersects the first power main line and the second power main line.

The first emission area emits light of a first wavelength band. The second emission area emits light of a second wavelength band lower than the first wavelength band. The third emission area emits light of a third wavelength band lower than the second wavelength band. Each of the light emitting elements comprises an anode electrode and a cathode electrode opposing each other in a third direction, and an organic layer located between the anode electrode and the cathode electrode. Each of the organic layer of the light emitting element of the first emission area and the organic layer of the light emitting element of the second emission area comprises one light emitting stack. The organic layer of the light emitting element of the third emission area comprises two or more light emitting stacks, and at least one carrier generation layer located between the two or more light emitting stacks. Each of the one light emitting stack and the two or more light emitting stacks comprises a light emitting layer in which an electron-hole pair is converted into light.

According to an aspect of the present disclosure, there is provided an electronic device comprises a display device displaying an image; a memory storing an application; one or more processors executing the application and transmitting an image data signal and an input control signal to the display device; and a power module transmitting power to the display device. The display device comprises a substrate comprising a display area in which emission areas are arranged; and a circuit layer located on the substrate. The circuit layer comprises light emitting pixel drivers arranged in a first direction and a second direction; a first power main line extending in the first direction and transmitting a first power to the light emitting pixel drivers; and a second power main line extending in the first direction and transmitting a second power different from the first power to some of the light emitting pixel drivers.

Each of the light emitting pixel drivers comprises a first transistor generating a driving current; a second transistor electrically connected between a data line that transmits a data signal and a gate electrode of the first transistor; a third transistor electrically connected between a reference voltage line that transmits a reference voltage and the gate electrode of the first transistor; a first capacitor electrically connected between the gate electrode of the first transistor and a first node; a second capacitor electrically connected between the first power main line and the first node; a fourth transistor electrically connected between an initialization voltage line that transmits an initialization voltage and a second node; a fifth transistor electrically connected to a first electrode of the first transistor; and a sixth transistor electrically connected between the first node and the second node. The first node is electrically connected to a second electrode of the first transistor. The second node is electrically connected to one of light emitting elements.

The display device further comprises an element layer located on the circuit layer. The element layer comprises the light emitting elements arranged in each of the emission areas. The emission areas comprise a first emission area, a second emission area, and a third emission area that emit light of different wavelength bands. The light emitting pixel drivers comprise a first light emitting pixel driver electrically connected to a light emitting element of the first emission area; a second light emitting pixel driver electrically connected to a light emitting element of the second emission area; and a third light emitting pixel driver electrically connected to a light emitting element of the third emission area. The fifth transistor of the first light emitting pixel driver and the fifth transistor of the second light emitting pixel driver are electrically connected to the first power main line. The fifth transistor of the third light emitting pixel driver is electrically connected to the second power main line.

The circuit layer comprises a light blocking conductive layer located on the substrate; a buffer layer covering the light blocking conductive layer; a first semiconductor layer located on the buffer layer; a first gate insulating layer covering the first semiconductor layer; a first gate conductive layer located on the first gate insulating layer; a second gate insulating layer covering the first gate conductive layer; a second gate conductive layer located on the second gate insulating layer; a first interlayer insulating layer covering the second gate conductive layer; a second semiconductor layer located on the first interlayer insulating layer; a third gate insulating layer covering the second semiconductor layer; a third gate conductive layer located on the third gate insulating layer; a second interlayer insulating layer covering the third gate conductive layer; a first source-drain conductive layer located on the second interlayer insulating layer; a first planarization layer covering the first source-drain conductive layer; a second source-drain conductive layer located on the first planarization layer; and a second planarization layer covering the second source-drain conductive layer. A channel portion, the first electrode, and the second electrode of the first transistor are located in the second semiconductor layer. A channel portion, a first electrode, and a second electrode of the fifth transistor are located in the first semiconductor layer.

The first transistor comprises a main gate electrode located in the second gate conductive layer, overlapping the channel portion of the first transistor, and electrically connected to the second transistor and the third transistor; and a sub-gate electrode located in the third gate conductive layer, overlapping the channel portion of the first transistor, and electrically connected to the second electrode of the first transistor. The first power main line is located in the first source-drain conductive layer. Each of the light emitting pixel drivers comprises a first capacitor electrode located in the first gate conductive layer and electrically connected to the second electrode of the first transistor and the sub-gate electrode; a second capacitor electrode located in the second gate conductive layer and electrically connected to the main gate electrode; and a third capacitor electrode located in the second gate conductive layer, spaced apart from the second capacitor electrode, and electrically connected to the first power main line. The first capacitor is formed by a region where the first capacitor electrode and the second capacitor electrode overlap in a third direction. The second capacitor is formed by a region where the first capacitor electrode and the third capacitor electrode overlap in the third direction, and a region where the sub-gate electrode of the first transistor and the first power main line overlap in the third direction.

Each of the light emitting pixel drivers further comprises a third capacitor electrically connected between an additional power line and the first node. The additional power line is located in the light blocking conductive layer and transmits one of the first power, the second power, and a third power. The third power is different from the first power and the second power. The third capacitor is formed by a region where the first capacitor electrode and the additional power line overlap in the third direction.

The first power main line is located in the first source-drain conductive layer. The second power main line is located in the third gate conductive layer. The circuit layer further comprises a first power sub-line extending in the second direction and electrically connected to the first power main line; and a second power sub-line extending in the second direction and electrically connected to the second power main line. The data line, the first power sub-line and the second power sub-line are located in the second source-drain conductive layer.

Each of the light emitting pixel drivers intersects the first power main line and the second power main line.

The first emission area emits light of a first wavelength band. The second emission area emits light of a second wavelength band lower than the first wavelength band. The third emission area emits light of a third wavelength band lower than the second wavelength band. Each of the light emitting elements comprises an anode electrode and a cathode electrode opposing each other in a third direction, and an organic layer located between the anode electrode and the cathode electrode. Each of the organic layer of the light emitting element of the first emission area and the organic layer of the light emitting element of the second emission area comprises one light emitting stack. The organic layer of the light emitting element of the third emission area comprises two or more light emitting stacks, and at least one carrier generation layer located between the two or more light emitting stacks. Each of the one light emitting stack and the two or more light emitting stacks comprises a light emitting layer in which an electron-hole pair is converted into light.

The display device according to an embodiment includes a circuit layer located on a substrate, and the circuit layer includes light emitting pixel drivers that transmit a driving current to light emitting elements, a first power main line for transmitting a first power to the light emitting pixel drivers, and a second power main line for transmitting a second power different from the first power to some of the light emitting pixel drivers.

In this way, some (e.g. a subset) of the light emitting pixel drivers may generate a driving current corresponding to the second power, while some others thereof may generate a driving current corresponding to the first power.

Accordingly, the light emitting element electrically connected to some (e.g. a subset) of the light emitting pixel drivers may be driven by a driving current corresponding to the second power, thereby improving luminance and improving the display quality of the display device.

In addition, one of the first power and the second power may be selected according to the voltage-current characteristics of the light emitting element, so that the power of the display device may not be unnecessarily consumed. As a result, the power consumption of the display device and the electronic device including the same may be reduced.

It should be noted that effects of the present disclosure are not limited to those described above and other effects of the present disclosure will be apparent to those skilled in the art from the following descriptions.

### BRIEF DESCRIPTION OF THE DRAWINGS

The above and other aspects and features of the present disclosure will become more apparent by describing in detail embodiments thereof with reference to the attached drawings.
FIG. 1 is a perspective view showing an electronic device according to an embodiment.
FIG. 2 is an exploded perspective view of the electronic device shown in FIG. 1.
FIG. 3 is a plan view illustrating the display device of FIG. 2.
FIG. 4 is a cross-sectional view taken along line A-A' of FIG. 3.
FIG. 5 is a schematic diagram showing part B of FIG. 3.
FIG. 6 is a cross-sectional view taken along line C-C' of FIG. 5.
FIG. 7 is a cross-sectional view showing the first light emitting element of FIG. 6 in detail.
FIG. 8 is a cross-sectional view showing the third light emitting element of FIG. 6 in detail.
FIG. 9 is a block diagram showing the display device of FIG. 2.
FIG. 10 is an equivalent circuit diagram showing the first light emitting pixel driver of FIG. 5.
FIG. 11 is an equivalent circuit diagram showing the third light emitting pixel driver of FIG. 5.
FIG. 12 is a schematic view showing the circuit layer of part D of FIG. 5 according to an embodiment.
FIG. 13 is a schematic view showing the circuit layer of part D of FIG. 5 according to an embodiment.
FIG. 14 is a schematic view showing the circuit layer of part D of FIG. 5 according to an embodiment.
FIG. 15 is a schematic view showing the circuit layer of part D of FIG. 5 according to an embodiment.
FIGS. 16, 17, 18, 19, 20, 21, 22, and 23 are plan views illustrating the circuit layer of part E of FIG. 5 according to an embodiment of FIG. 15.
FIG. 24 is a cross-sectional view taken along line F-F' of FIG. 23.
FIG. 25 is a cross-sectional view taken along line G-G' of FIG. 23.
FIG. 26 is a cross-sectional view taken along line H-H' of FIG. 23.
FIG. 27 is a block diagram of an electronic device according to an embodiment.
FIG. 28 is schematic views of electronic devices according to various embodiments.

### DETAILED DESCRIPTION OF THE EMBODIMENTS

The embodiments will now be described more fully hereinafter with reference to the accompanying drawings. The embodiments may, however, be provided in different forms and should not be construed as limiting. The same reference numbers indicate the same components throughout the disclosure. In the accompanying figures, the thickness of layers and regions may be exaggerated for clarity.

Some of the parts which are not associated with the description may not be provided in order to describe embodiments of the disclosure.

It will also be understood that when a layer is referred to as being "on" another layer or substrate, it can be directly on the other layer or substrate, or intervening layers may also be present. In contrast, when an element is referred to as being "directly on" another element, there may be no intervening elements present.

Further, the phrase "in a plan view" means when an object portion is viewed from above, and the phrase "in a schematic cross-sectional view" means when a schematic cross-section taken by vertically cutting an object portion is viewed from the side. The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art. The expression "not overlap" may include meaning such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

The spatially relative terms "below," "beneath," "lower," "above," "upper," or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

When an element is referred to as being "connected" or "coupled" to another element, the element may be "directly connected" or "directly coupled" to another element, or "electrically connected" or "electrically coupled" to another element with one or more intervening elements interposed therebetween. It will be further understood that when the terms "comprises," "comprising," "has," "have," "having," "includes" and/or "including" are used, they may specify the presence of stated features, integers, steps, operations, elements and/or components, but do not preclude the presence or addition of other features, integers, steps, operations, elements, components, and/or any combination thereof.

It will be understood that, although the terms "first," "second," "third," or the like may be used herein to describe various elements, these elements should not be limited by these terms. These terms are used to distinguish one element from another element or for the convenience of description and explanation thereof. For example, when "a first element" is discussed in the description, it may be termed "a second element" or "a third element," and "a second element" and "a third element" may be termed in a similar manner without departing from the teachings herein.

The terms "about" or "approximately" as used herein is inclusive of the stated value and means within an acceptable range of deviation for the particular value as determined by one of ordinary skill in the art, considering the measurement in question and the error associated with measurement of the particular quantity (for example, the limitations of the measurement system). For example, "about" may mean within one or more standard deviations, or within ± 30%, 20%, 10%, 5% of the stated value.

In the specification and the claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or." In the specification and the claims, the phrase "at least one of" is intended to include the meaning of "at least one selected from the group of" for the purpose of its meaning and interpretation. For example, "at least one of A and B" may be understood to mean "A, B, or A and B."

Unless otherwise defined or implied, all terms used herein (including technical and scientific terms) have the same meaning as commonly understood by those skilled in the art to which this disclosure pertains. It will be further understood that terms, such as those defined in commonly used dictionaries, should be interpreted as having a meaning that is consistent with their meaning in the context of the relevant art and will not be interpreted in an ideal or excessively formal sense unless clearly defined in the specification.

Hereinafter, embodiments will be described with reference to the accompanying drawings.

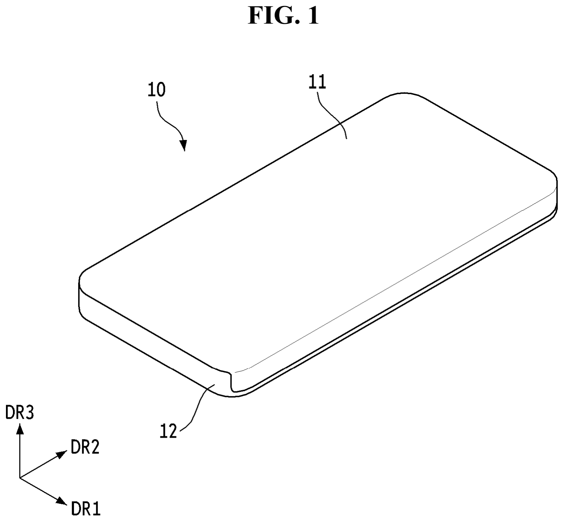

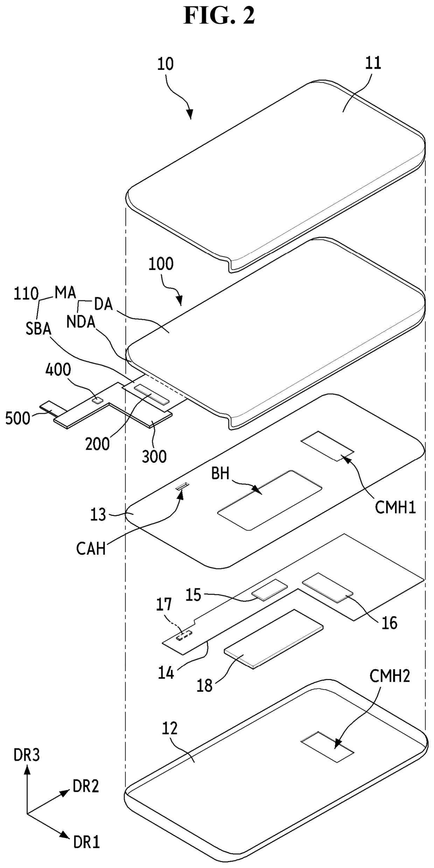

FIG. 1 is a perspective view showing an electronic device 10 according to an embodiment. FIG. 2 is an exploded perspective view of the electronic device 10 shown in FIG. 1.

Referring to FIG. 1, the electronic device 10 according to an embodiment is a device having a function of displaying an image in a display area. The electronic device 10 may provide portability. For example, the electronic device 10 may be a portable electronic device such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC).

The electronic device 10 according to an embodiment is not limited to a portable electronic device, and may be a large-sized device such as a television, a laptop computer, a monitor, a billboard, and an Internet-of-Things (IoT) device.

The electronic device 10 may have a shape close to a rectangular shape in plan view. For example, the electronic device 10 may have a rectangular shape, in plan view, having a short side in a first direction DR1 and a long side in a second direction DR2. A corner where the short side in the first direction DR1 and the long side in the second direction DR2 meet may be right-angled or rounded with a selected curvature. The planar shape of the electronic device 10 is not limited to the rectangular shape, and may be formed in another polygonal shape, a circular shape or an elliptical shape.

In the present specification, the first direction DR1 may be a direction parallel to a short side of the electronic device 10 in plan view, that is, a horizontal direction of the electronic device 10. The second direction DR2 may be a direction parallel to a long side of the electronic device 10 in plan view, that is, a vertical direction of the electronic device 10. A third direction DR3 may be a thickness direction of the electronic device 10.

The electronic device 10 according to an embodiment may include a display device 100 (see FIG. 2). The electronic device 10 may include a cover window 11 and a lower cover 12, which are provided as a housing to protect the display device 100 (see FIG. 2).

Referring to FIG. 2, the electronic device 10 may further include a bracket 13 and a main circuit board 14, which are accommodated between the cover window 11 and the lower cover 12.

The electronic device 10 may include a display surface on which a display area DA where an image display is implemented is located.

The display device 100 may include the display area DA that emits light toward the display surface of the electronic device 10.

The cover window 11 may be located on the display device 100 to cover the top surface of the display device 100. The cover window 11 may serve to protect the top surface of the display device 100.

The cover window 11 may include a light transmitting portion that is transparent and a light blocking portion that is opaque.

The light transmitting portion of the cover window 11 may overlap the display area DA of the display device 100 in the third direction DR3, and the light blocking portion of the cover window 11 may overlap a non-display area NDA of the display device 100 in the third direction DR3.

The cover window 11 may include a top surface portion forming the top surface of the electronic device 10, a left surface portion forming the left side surface of the electronic device 10, and a right surface portion forming the right side surface of the electronic device 10. The left surface portion of the cover window 11 may extend from the left side of the top surface portion, and the right surface portion thereof may extend from the right side of the top surface portion.

Each of the top, left, and right surface portions of the cover window 11 may include the light transmitting portion and the light blocking portion.

The light transmitting portion of the cover window 11 may be located on most of each of the top, left, and right surface portions of the cover window 11.

The light blocking portion of the cover window 11 may be located at the upper edge and lower edge of the top surface portion of the cover window 11, the upper edge, left edge, and lower edge of the left surface portion of the cover window 11, and the upper edge, right edge, and lower edge of the right surface portion of the cover window 11.

The display device 100 may include a top surface portion facing the top surface portion of the cover window 11, a left surface portion facing the left surface portion of the cover window 11, and a right surface portion facing the right surface portion of the cover window 11. The left surface portion of the display device 100 may extend from the left side of the top surface portion, and the right surface portion of the display device 100 may extend from the right side of the top surface portion.

The display device 100 may include the display area DA for displaying an image.

Each of the top, left, and right surface portions of the display device 100 may include the display area DA.

The display area DA may be located on most of each of the top, left, and right surface portions of the display device 100.

The display device 100 may further include a display driving circuit 200, a display circuit board 300, a touch driving circuit 400, and a cable 500 extending from one side of the display circuit board 300.

The bracket 13 may be located under the display device 100.

The bracket 13 may include plastic, metal, or both plastic and metal. The bracket 13 may include a first camera hole CMH1 into which a camera device 16 is inserted, a battery hole BH for holding a battery 18, and a cable hole CAH serving as a passage of the cable 500 connected to the display circuit board 300.

The main circuit board 14 and the battery 18 may be located under the bracket 13. The main circuit board 14 may be a printed circuit board or a flexible printed circuit board.

A main processor 15, the camera device 16, and a main connector 17 may be mounted on the main circuit board 14.

The camera device 16 may be located on both the top surface and the bottom surface of the main circuit board 14, the main processor 15 may be located on the top surface of the main circuit board 14, and the main connector 17 may be located on the bottom surface of the main circuit board 14.

The main processor 15 may control all functions of the electronic device 10.

For example, the main processor 15 may output digital video data to the display driving circuit 200 through the display circuit board 300 such that the display device 100 displays an image. In addition, the main processor 15 may receive touch data including user's touch coordinates from the touch driving circuit 400, determine whether or not the user has touched or approached, and then perform an operation corresponding to the user's touch input or approach input. For example, the main processor 15 may perform an operation or execute an application indicated by an icon touched by the user.

The main processor 15 may be one or more processors and may be an application processor formed as an integrated circuit, a central processing unit, or a system chip.

The camera device 16 may process an image frame of a still image or video obtained by an image sensor in a camera mode and output it to the main processor 15.

The cable 500 passing through the cable hole CAH of the bracket 13 may be connected to the main connector 17. Thus, the main circuit board 14 may be electrically connected to the display circuit board 300.

The battery 18 may be spaced apart from the main circuit board 14. That is, the battery 18 may not overlap the main circuit board 14 in the third direction DR3. The battery 18 may be located in the battery hole BH of the bracket 13 in the third direction DR3.

In addition, the main circuit board 14 may be further equipped with a mobile communication module capable of transmitting and receiving radio signals with at least one of a base station, an external terminal, or a server in a mobile communication network. The radio signal may include various types of data according to transmission and reception of a voice signal, a video call signal, or a text/multimedia message.

The lower cover 12 may be located below the main circuit board 14 and the battery 18. The lower cover 12 may be fixed by being fastened to the bracket 13. The lower cover 12 may form the upper side surface, the lower side surface, and the bottom surface of the electronic device 10. The lower cover 12 may include plastic, metal, or both plastic and metal.

The lower cover 12 may include a second camera hole CMH2 through which the bottom surface of the camera device 16 is exposed.

However, the positions of the first camera hole CMH1 and the second camera hole CMH2 are not limited to those shown in FIG. 2.

Next, the display device 100 according to embodiments will be described.

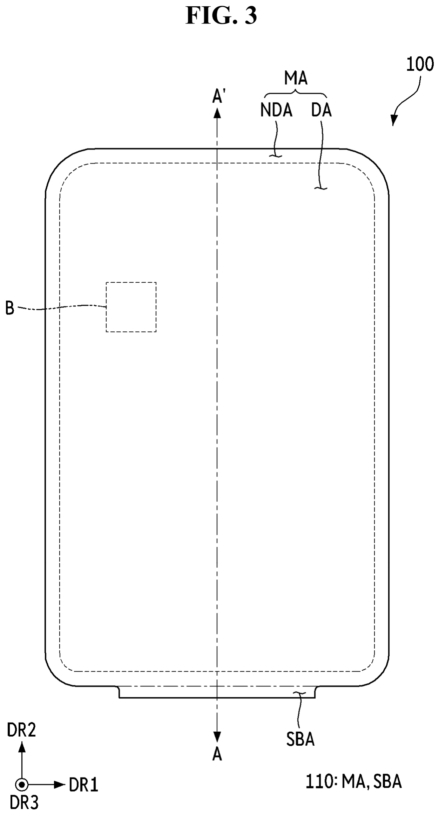

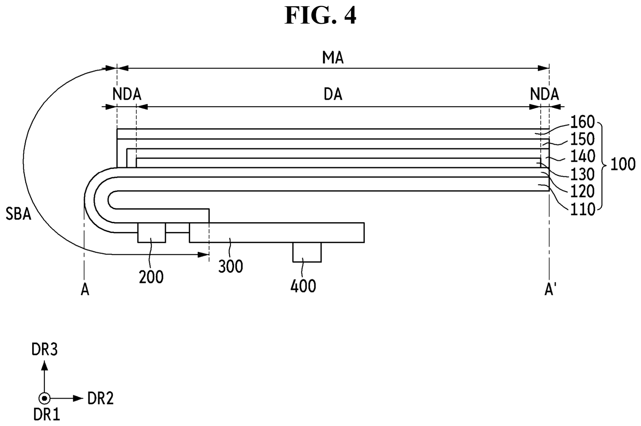

FIG. 3 is a plan view illustrating the display device 100 of FIG. 2. FIG. 4 is a cross-sectional view taken along line A-A' of FIG. 3.

Referring to FIGS. 3 and 4, the display device 100 according to an embodiment may be a light emitting display device, such as an organic light emitting display device using an organic light emitting diode, a quantum dot light emitting display device including a quantum dot light emitting layer, an inorganic light emitting display device including an inorganic semiconductor, and an ultra-small light emitting display device using an ultra-small light emitting diode (a micro or nano light emitting diode (micro LED or nano LED)). In the following description, it is assumed that the display device 100 is an organic light emitting display device. However, the present disclosure is not limited thereto, and may be applied to a display device including an organic insulating material, an organic light emitting material, and a metal material.

The display device 100 may be formed to be flat, but is not limited thereto. For example, the display device 100 may include a curved portion formed at left and right ends and having a constant curvature or a varying curvature. In addition, the display device 100 may be formed to be flexible so that it can be curved, bent, folded, or rolled.

Referring to FIG. 3, at least one surface of the display device 100 includes a main region MA from which light for displaying an image is emitted.

The display area DA may, in plan view, be formed in a rectangular shape having short sides in the first direction DR1 and long sides in the second direction DR2 crossing the first direction DR1. The corner where the short side in the first direction DR1 and the long side in the second direction DR2 meet may be rounded to have a selected curvature or may be right-angled. The planar shape of the display area DA is not limited to the rectangular shape, and may be formed in another polygonal shape, a circular shape or an elliptical shape.

The display area DA may be located in most of the main region MA. The display area DA may be located at the center of the main region MA.

The non-display area NDA may be located around the display area DA. That is, the display area DA may be surrounded by the non-display area NDA.

The display device 100 may include a substrate 110 including the main region MA and a sub-region SBA.

Referring to FIG. 4, the sub-region SBA may protrude from at least a part of one side of the main region MA in the second direction DR2.

Since a part of the sub-region SBA is transformed into a bent shape, another part of the sub-region SBA may be located on the rear surface of the display device 100.

According to an embodiment, the display device 100 includes the substrate 110, a circuit layer 120 located on the substrate 110, and an element layer 130 located on the circuit layer 120.

The display device 100 may further include an encapsulation layer 140 located on the element layer 130, and a touch sensor layer 150 located on the encapsulation layer 140.

The display device 100 may further include a polarization layer 160 located on the touch sensor layer 150, in order to reduce reflection of external light.

The substrate 110 may include the main region MA corresponding to the display surface, and the sub-region SBA protruding in the second direction DR2 from at least a part of one side of the main region MA.

The main region MA may include the display area DA from which light is emitted, and the non-display area NDA located around the display area DA.

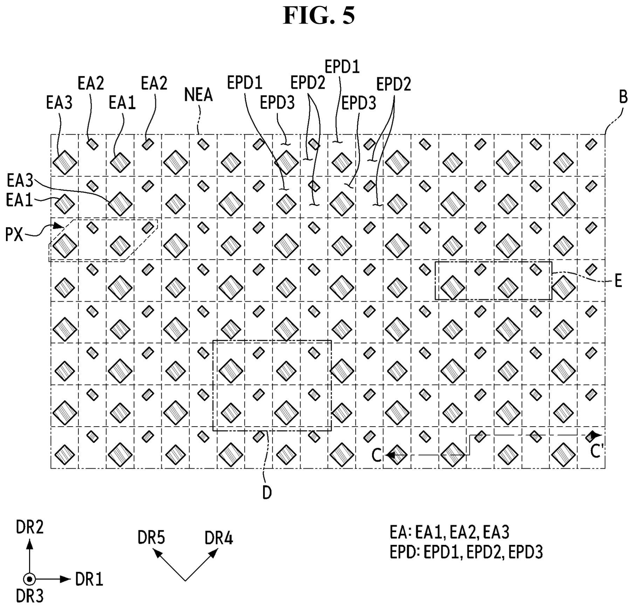

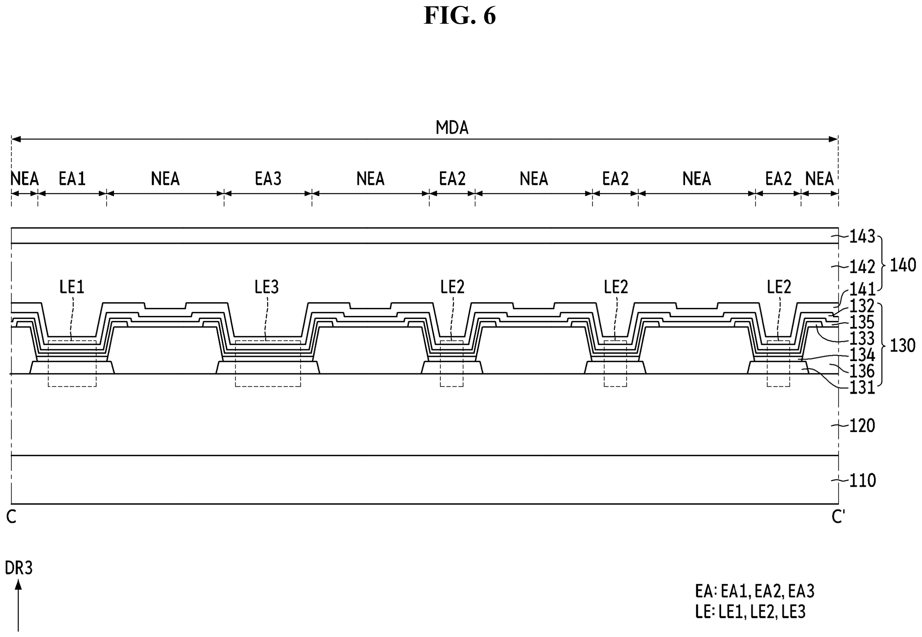

The element layer 130 may include light emitting elements LE (see FIG. 6) respectively located in emission areas EA (see FIG. 5).

The circuit layer 120 may include light emitting pixel drivers EPD (see FIG. 5) electrically connected to the light emitting elements LE.

The encapsulation layer 140 may cover the element layer 130. The encapsulation layer 140 may include a structure in which two or more inorganic layers and at least one organic layer are alternately stacked.

The touch sensor layer 150 may be located on the encapsulation layer 140 and may correspond to the main region MA. The touch sensor layer 150 may include touch electrodes for sensing a touch of a person or an object.

The polarization layer 160 blocks external light reflected from the touch sensor layer 150, the encapsulation layer 140, the element layer 130, and the circuit layer 120, and the interfaces thereof, and this is to prevent the deterioration of visibility of an image due to external light reflection.

As a part of the sub-region SBA is transformed into a bent shape, the display driving circuit 200 mounted in the sub-region SBA, and the display circuit board 300 connected to one side of the sub-region SBA may be located under the substrate 110.

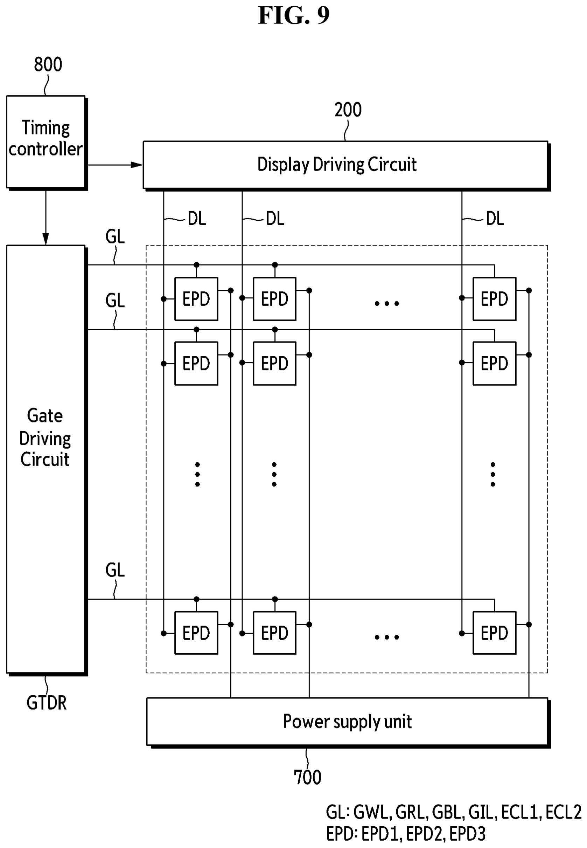

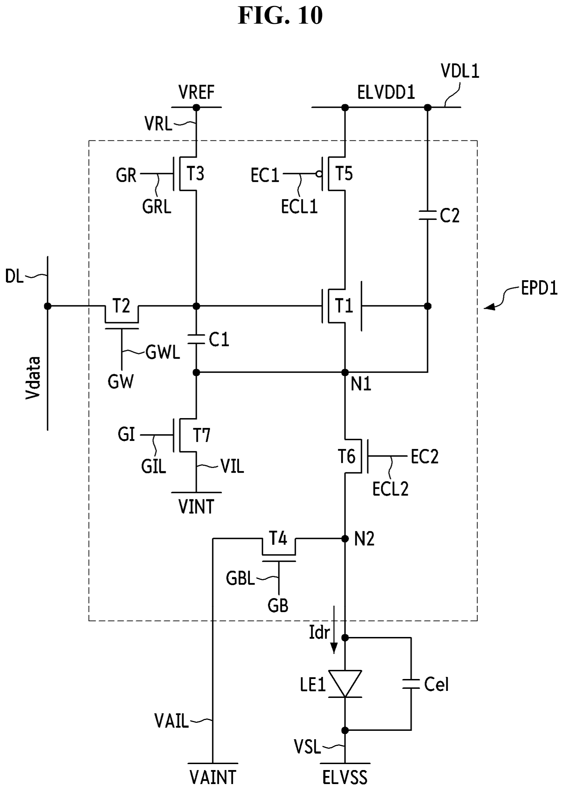

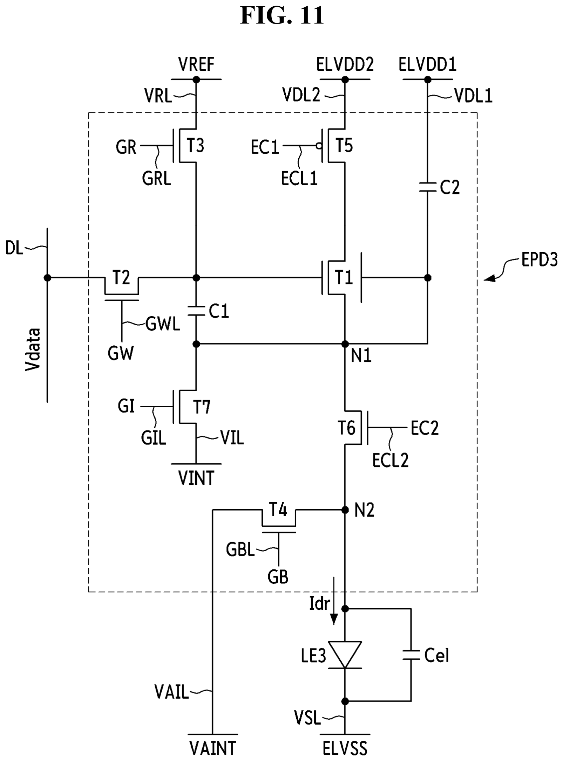

The display driving circuit 200 may be electrically connected to the data lines DL (see FIG. 9) of the circuit layer 120. The display driving circuit 200 may transmit data signals Vdata (see FIGS. 10 and 11) of the light emitting pixel drivers EPD (see FIGS. 5 and 9) to the data lines DL based on control signals and power and voltages supplied from the display circuit board 300.

The display driving circuit 200 may be provided as an integrated circuit (IC) and mounted on the sub-region SBA of the display device 100 by a chip on glass (COG) method, a chip on plastic (COP) method, or an ultrasonic method. However, this is only an example, and an embodiment is not limited thereto. For example, the display driving circuit 200 may be mounted on the display circuit board 300.

One end of the display circuit board 300 may be attached onto pads located on one edge of the sub-region SBA of the display device 100 by using an anisotropic conductive film.

The display circuit board 300 may be a flexible printed circuit board (FPCB) which is bendable, a rigid printed circuit board (PCB) which maintains a flat shape, or a composite printed circuit board having both of the rigid printed circuit board and the flexible printed circuit board.

The display circuit board 300 may be connected to signal pads located on one side of the sub-region SBA.

The touch driving circuit 400 may be mounted on the display circuit board 300.

The touch driving circuit 400 may be electrically connected to the touch sensor layer 150.

The touch driving circuit 400 may apply a touch driving signal to driving lines of the touch sensor layer 150, and receive a touch sensing signal from sensing lines. Further, the touch driving circuit 400 may detect charge variation amounts of capacitances based on the touch sensing signal, thereby determining whether a user has touched or approached.

The user's touch means that an object such as a pen or a user's finger is in direct contact with the top surface of the cover window located on the touch sensor layer. The user's approach means that the object such as the pen or the user's finger hovers over the top surface of the cover window.

The touch driving circuit 400 may output touch data including the user's touch coordinates to the main processor 15 (see FIG. 2).

FIG. 5 is a schematic diagram showing part B of FIG. 3. FIG. 6 is a cross-sectional view taken along line C-C' of FIG. 5.

As shown in FIG. 5, the display area DA may include the emission areas EA.

The display area DA may further include a non-emission area NEA, which is a separation area between the emission areas EA and does not emit light.

Light for image display may be emitted through the emission areas EA.

Each of the emission areas EA may be a unit area that emits light in a wavelength band corresponding to one color of two or more different colors with a luminance corresponding to an image signal.

Each of the emission areas EA may be arranged in a quadrilateral shape.

However, this is only an example, and the planar shape of the emission areas EA according to an embodiment is not limited to that illustrated in FIG. 5. That is, the emission areas EA may have, in plan view, a circular shape, an elliptical shape, or a polygonal shape such as a rectangle, a square, a hexagon, or an octagon, rather than a rhombus.

The emission areas EA may include first emission areas EA1 that emit light in a first wavelength band, second emission areas EA2 that emit light in a second wavelength band lower than the first wavelength band, and third emission areas EA3 that emit light in a third wavelength band lower than the second wavelength band.

For example, the first wavelength band may be from about 600 nm to about 750 nm and may correspond to a red color. The second wavelength band may be from about 480 nm to about 560 nm and may correspond to a green color. The third wavelength band may be from about 370 nm to about 460 nm and may correspond to a blue color.

However, this is only an example, and the first wavelength band, the second wavelength band, and the third wavelength band according to an embodiment are not limited thereto.

Since the emission areas EA include the first emission area EA1, the second emission area EA2, and the third emission area EA3, each of unit pixels PX may be provided by a combination of one or more first emission areas EA1, one or more second emission areas EA2, and one or more third emission areas EA3 adjacent to each other among the emission areas EA.

Each of the unit pixels PX may be a unit for displaying various colors including white. That is, lights of various colors displayed by the unit pixels PX may be implemented as a mixture of lights emitted from two or more emission areas EA included in each unit pixel PX.

The third emission area EA3 may have a width greater than that of the first emission area EA1, and the first emission area EA1 may have a width greater than that of the second emission area EA2. However, this is merely an example, and the width of each of the emission areas EA is not limited to that illustrated in FIG. 5.

The first emission areas EA1 and the third emission areas EA3 may be alternately arranged in the first direction DR1 and the second direction DR2.

The second emission area EA2 may be arranged parallel to each other in the first direction DR1 and the second direction DR2.

Each of the second emission areas EA2 may be adjacent to the first emission area EA1 or the third emission area EA3 in diagonal directions DR4 and DR5 intersecting the first direction DR1 and the second direction DR2.

In this case, each of the unit pixels PX may include one first emission area EA1 and one third emission area EA3 adjacent to each other in the first direction DR1, and two second emission areas EA2 adjacent thereto in the diagonal directions DR4 and DR5. However, this is only an example, and the arrangement pattern of the emission areas EA and the components of the unit pixel PX according to an embodiment are not limited to the above description.

Referring to FIG. 6, according to an embodiment, the element layer 130 (see FIG. 4) may include the light emitting elements LE arranged in the emission areas EA.

The light emitting elements LE may include a first light emitting element LE1 located in the first emission area EA1, a second light emitting element LE2 located in the second emission area EA2, and a third light emitting element LE3 located in the third emission area EA3.

The first light emitting element LE1 may emit light of the first wavelength band.

The second light emitting element LE2 may emit light of the second wavelength band.

The third light emitting element LE3 may emit light of the third wavelength band.

As shown in FIG. 5, according to an embodiment, the circuit layer 120 (see FIG. 4) may include the light emitting pixel drivers EPD arranged in the first direction DR1 and the second direction DR2.

The light emitting pixel drivers EPD may respectively transmit a driving current Idr (see FIGS. 10 and 11) to the light emitting elements LE (see FIG. 6) of the element layer 130 (see FIG. 4).

The light emitting pixel drivers EPD may include a first light emitting pixel driver EPD1 electrically connected to the first light emitting element LE1 (see FIG. 6), a second light emitting pixel driver EPD2 electrically connected to the second light emitting element LE2 (see FIG. 6), and a third light emitting pixel driver EPD3 electrically connected to the third light emitting element LE3 (see FIG. 6).

The first light emitting pixel driver EPD1 and the third light emitting pixel driver EPD3 may be alternately arranged in the second direction DR2.

The second light emitting pixel drivers EPD2 may be arranged side by side in the second direction DR2.

Each of the second light emitting pixel drivers EPD2 may be located between the first light emitting pixel driver EPD1 and the third light emitting pixel driver EPD3 in the first direction DR1.

As shown in FIG. 6, the element layer 130 may include the light emitting elements LE respectively located in the emission areas EA, respectively.

Each of the light emitting elements LE may be an organic light emitting diode including an organic layer of an organic light emitting material.

In an embodiment, each of the light emitting elements LE may be one of an inorganic light emitting element having a light emitting layer including an inorganic semiconductor, a quantum dot light emitting element having a quantum dot light emitting layer, and a micro light emitting diode.

According to an embodiment, each of the light emitting elements LE may include an anode electrode 131 and a cathode electrode 132 opposing each other, and an organic layer 133 located between the anode electrode 131 and the cathode electrode 132.

According to an embodiment, each of the light emitting elements LE may further include a first common layer 134 located between the anode electrode 131 and the organic layer 133, and a second common layer 135 located between the organic layer 133 and the cathode electrode 132.

The first common layer 134 may contain an organic material for injecting holes.

The second common layer 135 may contain an organic material for injecting electrons.

That is, the element layer 130 may include the anode electrodes 131 located in the emission areas EA, a pixel defining layer 136 located in the non-emission area NEA and covering the edges of the anode electrodes 131, the first common layers 134 located on the anode electrodes 131, the organic layers 133 located on the first common layers 134, the second common layer 135 located on the organic layers 133 and the pixel defining layer 136, and the cathode electrode 132 located on the second common layer 135.

The anode electrodes 131 may be respectively located in the emission areas EA, and may be respectively electrically connected to the light emitting pixel drivers EPD (see FIG. 5) of the circuit layer 120. This anode electrode 131 may be referred to as a pixel electrode.

The pixel defining layer 132 may include an organic insulating material.

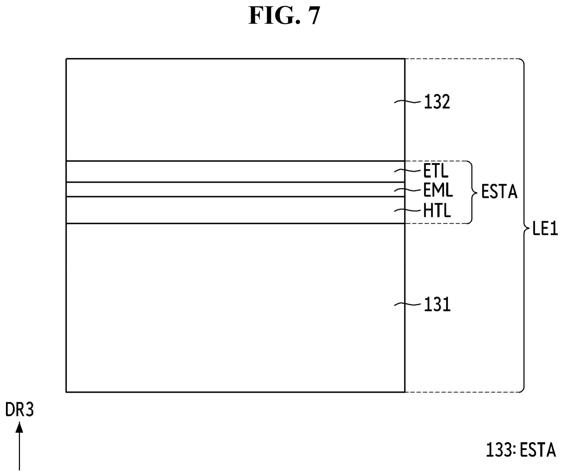

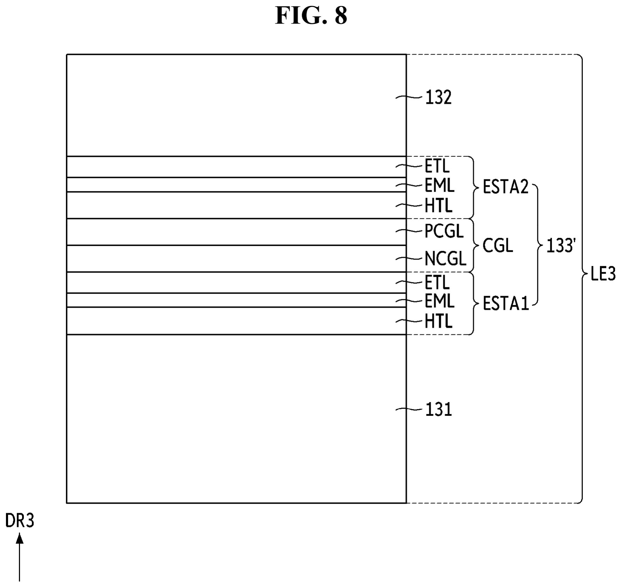

Each of the organic layers 133 may include at least one light emitting stack ESTA (see FIG. 7), or ESTA1 and ESTA2 (see FIG. 8). Each of the at least one light emitting stack ESTA (see FIG. 7), or ESTA1 and ESTA2 (see FIG. 8) may include a light emitting layer EML (see FIGS. 7 and 8) for converting an electron-hole pair into light.

The cathode electrode 132 may be located in the emission areas EA and the non-emission area NEA and may be electrically connected to a third power line VSL (see FIGS. 10 and 11). That is, the cathode electrode 132 may be located entirely in the display area DA. The cathode electrode 132 may be referred to as a common electrode.

The encapsulation layer 140 may be located on the circuit layer 120 and cover the element layer 130.

The encapsulation layer 140 may include a first encapsulation layer 141 located on the element layer 130 and containing an inorganic insulating material, a second encapsulation layer 142 covering the element layer 130 and containing an organic insulating material, and a third encapsulation layer 143 covering the second encapsulation layer 142 and containing an inorganic insulating material.

FIG. 7 is a cross-sectional view showing the first light emitting element of FIG. 6 in detail. FIG. 8 is a cross-sectional view showing the third light emitting element of FIG. 6 in detail.

As mentioned above, the element layer 130 of the display device 100 according to an embodiment includes the first light emitting element LE1 (see FIG. 6) located in the first emission area EA1 (see FIG. 6), the second light emitting element LE2 (see FIG. 6) located in the second emission area EA2 (see FIG. 6), and the third light emitting element LE3 (see FIG. 6) located in the third emission area EA3 (see FIG. 6).

As shown in FIGS. 7 and 8, according to an embodiment, each of the first light emitting element LE1 and the third light emitting element LE3 may include the anode electrode 131 and the cathode electrode 132 opposing each other in the third direction DR3, and the organic layer 133, 133' located between the anode electrode 131 and the cathode electrode 132.

As shown in FIG. 7, the organic layer 133 of the first light emitting element LE1 may include a single light emitting stack ESTA.

The single light emitting stack ESTA may include the light emitting layer EML in which an electron-hole pair is converted into light.

The single light emitting stack ESTA may further include a hole transport layer HTL located between the anode electrode 131 and the light emitting layer EML, and an electron transport layer ETL located between the light emitting layer EML and the cathode electrode 132.

According to an embodiment, the second light emitting element LE2 (see FIG. 6) may have a structure that is the same as or similar to that of the first light emitting element LE1 shown in FIG. 7, and thus a redundant description thereof will be omitted.

As shown in FIG. 8, the organic layer 133' of the third light emitting element LE3 may include two or more light emitting stacks ESTA1 and ESTA2, and at least one carrier generation layer CGL located between the two or more light emitting stacks ESTA1 and ESTA2. Luminance of the light emitting element of the colors may be increased, thereby improving the display quality of the display device.

Each of the two or more light emitting stacks ESTA1 and ESTA2 may include the light emitting layer EML in which an electron-hole pair is converted into light.

According to an embodiment, the two or more light emitting stacks ESTA1 and ESTA2 may include a first light emitting stack ESTA1 adjacent to the anode electrode 131 in the third direction DR3, and a second light emitting stack ESTA2 adjacent to the cathode electrode 132 in the third direction DR3.

According to an embodiment, the organic layer 133' of the third light emitting element LE3 may include one carrier generation layer CGL located between the first light emitting stack ESTA1 and the second light emitting stack ESTA2.

In this case, the first light emitting stack ESTA1 may further include the hole transport layer HTL located between the anode electrode 131 and the light emitting layer EML, and the electron transport layer ETL located between the light emitting layer EML and the carrier generation layer CGL.

In addition, the second light emitting stack ESTA2 may further include the hole transport layer HTL located between the carrier generation layer CGL and the light emitting layer EML, and the electron transport layer ETL located between the light emitting layer EML and the cathode electrode 132.

The carrier generation layer CGL may include an n-type carrier generation layer NCGL adjacent to the anode electrode 131 in the third direction DR3 and a p-type carrier generation layer PCGL adjacent to the cathode electrode 132 in the third direction DR3.

According to an embodiment, each of the first light emitting element LE1 and the second light emitting element LE2 includes a single light emitting stack ESTA (see FIG. 7), whereas the third light emitting element LE3 includes two or more light emitting stacks ESTA1 and ESTA2 (see FIG. 8). Accordingly, the driving voltage of the third light emitting element LE3 may differ from the driving voltage of the first light emitting element LE1 and the driving voltage of the second light emitting element LE2.

FIG. 9 is a block diagram showing the display device 100 of FIG. 2.

Referring to FIG. 9, the circuit layer 120 of the display device 100 according to an embodiment may include the light emitting pixel drivers EPD electrically connected to the light emitting elements LE (see FIG. 6) located in the emission areas EA of the display area DA.

The light emitting pixel drivers EPD may include the first light emitting pixel driver EPD1 electrically connected to the first light emitting element LE1 (see FIG. 6), the second light emitting pixel driver EPD2 electrically connected to the second light emitting element LE2 (see FIG. 6), and the third light emitting pixel driver EPD3 electrically connected to the third light emitting element LE3 (see FIG. 6).

According to an embodiment, the circuit layer 120 may further include gate lines GL for transmitting a gate signal to the light emitting pixel drivers EPD, and the data lines DL for transmitting the data signals Vdata (see FIG. 10) to the light emitting pixel drivers EPD.

The display device 100 may further include the display driving circuit 200 that outputs the data signals Vdata (see FIG. 10) for controlling the luminance of each of the light emitting elements LE (see FIG. 6) to the data lines DL.

The display device 100 may further include a gate driving circuit GTDR that outputs gate signals to the gate lines GL, a power supply unit 700 that supplies various powers and various voltages to the light emitting pixel drivers EPD, and a timing controller 800 that controls the driving timing of each of the display driving circuit 200 and the gate driving circuit GTDR.

The timing controller 800 receives an image signal supplied from the outside of the display device 100.

The timing controller 800 may output image data and a data control signal to the display driving circuit 200.

The timing controller 800 may generate a scan control signal for controlling the operation timing of the gate driving circuit GTDR.

The display driving circuit 200 may convert the image data into analog data voltages and output them to the data lines DL.

The gate driving circuit GTDR may generate gate signals in response to the scan control signal and sequentially output the gate signals to gate lines GL.

The gate lines GL may include a scan write line GWL for transmitting a scan write signal GW (see FIG. 10), a reset control line GRL for transmitting a reset control signal GR (see FIG. 10), an initialization control line GIL for transmitting an initialization control signal GI (see FIG. 10), a bias control line GBL for transmitting a bias control signal GB (see FIG. 10), a first emission control line ECL1 for transmitting a first emission control signal EC1 (see FIG. 10), and a second emission control line ECL2 for transmitting a second emission control signal EC2 (see FIG. 10).

The gate signals may have pulses that vary to a first gate level voltage or a second gate level voltage.

The power supply unit 700 may supply various power and voltages necessary for driving the light emitting pixel drivers EPD.

In one example, the power supply unit 700 may supply a first power ELVDD1 (see FIGS. 10 and 11), a second power ELVDD2 (see FIG. 11), and a third power ELVSS (see FIGS. 10 and 11) for generating a driving signal transmitted to the light emitting elements LE, a reference voltage VREF (see FIG. 10) and an additional initialization voltage VINT (see FIG. 10) for initializing the light emitting pixel drivers EPD, and an initialization voltage VAINT (see FIG. 10) for initializing the light emitting elements LE (see FIG. 10).

FIG. 10 is an equivalent circuit diagram showing the first light emitting pixel driver EPD1 of FIG. 5. FIG. 11 is an equivalent circuit diagram showing the third light emitting pixel driver EPD3 of FIG. 5.

Referring to FIGS. 10 and 11, the first light emitting pixel driver EPD1 may be electrically connected to the first light emitting element LE1, and the third light emitting pixel driver EPD3 may be electrically connected to the third light emitting element LE3.

The first light emitting pixel driver EPD1 may be electrically connected to a first power line VDL1 for transmitting the first power ELVDD1.

As shown in FIGS. 10 and 11, each of the first light emitting element LE1 and the third light emitting element LE3 may include an intrinsic parasitic capacitance Cel.

Since the second light emitting element LE2 has a structure substantially the same as or similar to that of the first light emitting element LE1, the second light emitting pixel driver EPD2 may have a structure substantially the same as or similar to that of the first light emitting pixel driver EPD1. Accordingly, redundant descriptions thereof will be omitted.

According to an embodiment, since the third light emitting element LE3 includes two or more light emitting stacks ESTA1 and ESTA2 (see FIG. 8), the third light emitting pixel driver EPD3 may be electrically connected to the first power line VDL1 for transmitting the first power ELVDD1 and a second power line VDL2 for transmitting the second power ELVDD2 different from the first power ELVDD1.

According to an embodiment, the second power ELVDD2 may have a lower voltage level than the first power ELVDD1.

Each of the first light emitting element LE1 and the third light emitting element LE3 may be electrically connected to the third power line VSL for transmitting the third power ELVSS different from the first power ELVDD1 and the second power ELVDD2.

The third power ELVSS may have a lower voltage level than the first power ELVDD1 and the second power ELVDD2.

As shown in FIG. 10, the first light emitting pixel driver EPD1 may be electrically connected to the first power line VDL1 for transmitting the first power ELVDD1, the data line DL for transmitting the data signal Vdata, a reference voltage line VRL for transmitting the reference voltage VREF, an initialization voltage line VAIL for transmitting the initialization voltage VAINT, and an additional initialization voltage line VIL for transmitting the additional initialization voltage VINT.

The first light emitting pixel driver EPD1 may be electrically connected to the scan write line GWL for transmitting the scan write signal GW, the reset control line GRL for transmitting the reset control signal GR, the initialization control line GIL for transmitting the initialization control signal GI, the bias control line GBL for transmitting the bias control signal GB, the first emission control line ECL1 for transmitting the first emission control signal EC1, and the second emission control line ECL2 for transmitting the second emission control signal EC2.

The first light emitting pixel driver EPD1 may include a first transistor T1 configured to generate the driving current Idr for driving the first light emitting element LE1, two or more transistors T2 to T7 electrically connected to the first transistor T1 or the first light emitting element LE1, and one or more capacitors C1 and C2.

According to an embodiment, the first light emitting pixel driver EPD1 may include the first transistor T1 configured to generate the driving current Idr, a second transistor T2 electrically connected between the data line DL for transmitting the data signal Vdata and the gate electrode of the first transistor T1, a third transistor T3 electrically connected between the reference voltage line VRL for transmitting the reference voltage VREF and the gate electrode of the first transistor T1, a first capacitor C1 electrically connected between the gate electrode of the first transistor T1 and a first node N1, a second capacitor C2 electrically connected between the first power line VDL1 and the first node N1, a fourth transistor T4 electrically connected between the initialization voltage line VAIL for transmitting the initialization voltage VAINT and a second node N2, a fifth transistor T5 electrically connected between the first electrode of the first transistor T1 and the first power line VDL1, and a sixth transistor T6 electrically connected between the first node N1 and the second node N2.

The first node N1 may be electrically connected to the second electrode of the first transistor T1.

The second node N2 may be electrically connected to the first light emitting element LE1.

According to an embodiment, the first light emitting pixel driver EPD1 may further include a seventh transistor T7 electrically connected between the additional initialization voltage line VIL for transmitting the additional initialization voltage VINT and the first node N1.

The second transistor T2 may be electrically connected between the gate electrode of the first transistor T1 and the data line DL.

The second transistor T2 may be turned on by the scan write signal GW of the scan write line GWL.

When the second transistor T2 is turned on, the data signal Vdata of the data line DL may be transmitted to the gate electrode of the first transistor T1.

When the voltage difference between the gate electrode of the first transistor T1 and the second electrode of the first transistor T1 is equal to or greater than the threshold voltage of the first transistor T1 due to the data signal Vdata applied to the gate electrode of the first transistor T1, the first transistor T1 may be turned on. Accordingly, a drain-source current of the first transistor T1 may be generated to have a magnitude corresponding to the data signal Vdata.

The third transistor T3 may be electrically connected between the gate electrode of the first transistor T1 and the reference voltage line VRL.

The third transistor T3 may be turned on by the reset control signal GR of the reset control line GRL.

When the third transistor T3 is turned on, the potential of the gate electrode of the first transistor T1 may be initialized to the reference voltage VREF of the reference voltage line VRL.

The fourth transistor T4 may be electrically connected between the second node N2 and the initialization voltage line VAIL.

The fourth transistor T4 may be turned on by the bias control signal GB of the bias control line GBL.

When the fourth transistor T4 is turned on, the potential of the anode electrode of the first light emitting element LE1 may be initialized to the initialization voltage VAINT of the initialization voltage line VAIL through the second node N2.

The fifth transistor T5 of the first light emitting pixel driver EPD1 may be electrically connected between the first electrode of the first transistor T1 and the first power line VDL1.

The fifth transistor T5 may be turned on by the first emission control signal EC1 of the first emission control line ECL1.

The sixth transistor T6 may be electrically connected between the second electrode of the first transistor T1 and the first light emitting element LE1.

The sixth transistor T6 may be turned on by the second emission control signal EC2 of the second emission control line ECL2.

When the fifth transistor T5 and the sixth transistor T6 are turned on, the first transistor T1 and the light emitting element LE are connected in series between the first power line VDL1 and the third power line VSL, and thus the driving current Idr generated by the first transistor T1 with a magnitude corresponding to the data signal Vdata may be transmitted to the first light emitting element LE1.

Accordingly, the first light emitting element LE1 may emit light having a luminance corresponding to the data signal Vdata transmitted to the first light emitting pixel driver EPD1.

The seventh transistor T7 may be electrically connected between the second electrode of the first transistor T1 and the additional initialization voltage line VIL.

The seventh transistor T7 may be turned on by the initialization control signal GI of the initialization control line GIL.

When the seventh transistor T7 is turned on, the potential of the first node N1 may be initialized to the additional initialization voltage VINT of the additional initialization voltage line VIL.

The first capacitor C1 may be electrically connected between the gate electrode of the first transistor T1 and the second electrode of the first transistor T1.

The first capacitor C1 may be charged with the data signal Vdata applied to the gate electrode of the first transistor T1, and the turn-on of the first transistor T1 may be maintained for a selected period due to the voltage charged in the first capacitor C1.

The second capacitor C2 may be electrically connected between the second electrode of the first transistor T1 and the first power line VDL1.

The voltage of the first capacitor C1 may correspond to the potential difference between the gate electrode of the first transistor T1 and the second electrode of the first transistor T1, may be changed by the data signal Vdata, and may be divided by the second capacitor C2.

That is, regardless of the potential variation of the gate electrode of the first transistor T1, a potential difference between the gate electrode of the first transistor T1 and the second electrode of the first transistor T1 may be maintained by the second capacitor C2.

According to an embodiment, the first transistor T1 may include a main gate electrode that faces one surface of a channel portion and is electrically connected to the second transistor T2 and the third transistor T3, and a sub-gate electrode that faces another surface of the channel portion and is electrically connected to the second electrode of the first transistor T1. That is, the channel portion of the first transistor T1 may be located between the main gate electrode and the sub-gate electrode.

Accordingly, when the data signal Vdata is applied to the main gate electrode of the first transistor T1 and the first transistor T1 is turned on, compared to a part of the channel portion of the first transistor T1 adjacent to the main gate electrode, another part of the channel portion of the first transistor T1 adjacent to the sub-gate electrode may be less activated.

Therefore, since the electron mobility in the channel portion of the first transistor T1 decreases, the slope of a current curve representing a relationship between the drain-source current and the voltage of the gate electrode of the first transistor T1 may become gentle. Accordingly, a driving voltage range of the first transistor T1 may be widened, which may facilitate luminance control.

According to an embodiment, the first transistor T1 may be an N-type MOSFET.

At least some of the second to seventh transistors T2 to T7 may be P-type MOSFETs.

For example, the fifth transistor T5 may be a P-type MOSFET, and the second transistor T2, the third transistor T3, the fourth transistor T4, the sixth transistor T6, and the seventh transistor T7 may be N-type MOSFETs.

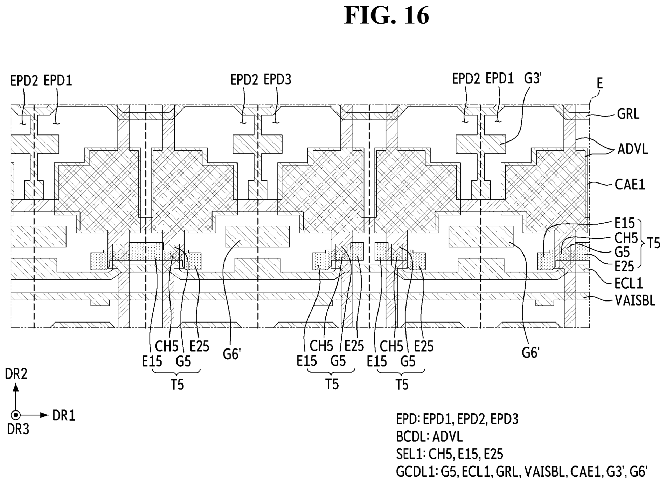

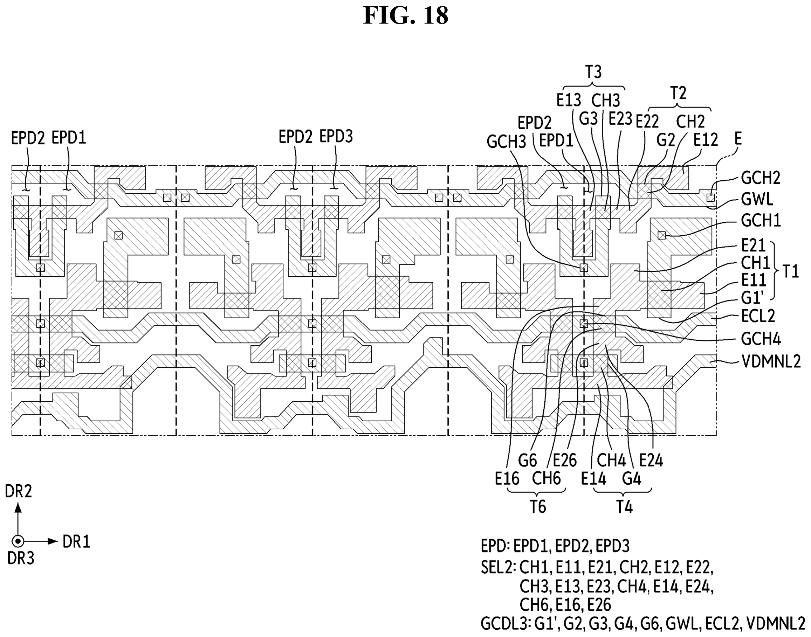

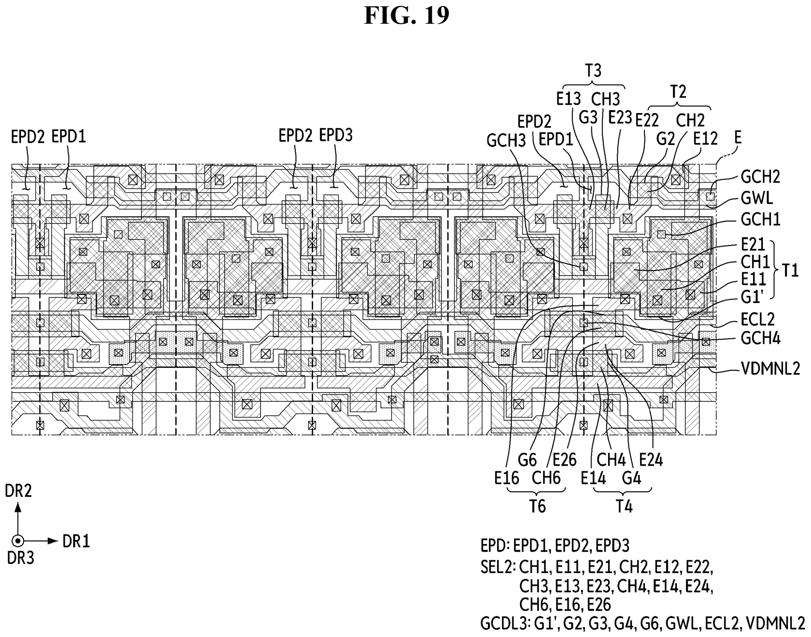

Accordingly, in an embodiment, the circuit layer 120 may include a first semiconductor layer SEL1 (see FIG. 16) for providing a P-type MOSFET and a second semiconductor layer SEL2 (see FIGS. 18 and 19) for providing an N-type MOSFET.

As shown in FIG. 11, the third light emitting pixel driver EPD3 is substantially the same as or similar to the first light emitting pixel driver EPD1 shown in FIG. 10, except that the third light emitting pixel driver EPD3 is electrically connected to the third light emitting element LE3 and the fifth transistor T5 is electrically connected to the second power line VDL2 for transmitting the second power ELVDD2, and thus a redundant description thereof will be omitted.

Since the third light emitting element LE3 includes two or more light emitting stacks ESTA1 and ESTA2 (see FIG. 8), a voltage level of the power for generating the driving current of the third light emitting element LE3 is different from a voltage level of the power for generating the driving current of the first light emitting element LE1.

Accordingly, in an embodiment, the fifth transistor T5 of the third light emitting pixel driver EPD3 may be electrically connected to the second power line VDL2, rather than the first power line VDL1.

That is, the fifth transistor T5 of the third light emitting pixel driver EPD3 may be electrically connected between the first electrode of the first transistor T1 and the second power line VDL2.

The second capacitor C2 of the third light emitting pixel driver EPD3 may be electrically connected to the first power line VDL1.

As described above, according to an embodiment, the driving current, e.g. of the third light emitting element LE3, may be generated using the second power ELVDD2 having a relatively low voltage level, thereby reducing power consumption of the display device 100 while maintaining high luminance of the third light emitting element LE3.

In addition, according to an embodiment, similarly to the second capacitor C2 of the first light emitting pixel driver EPD1, the second capacitor C2 of the third light emitting pixel driver EPD3 may be electrically connected to the first power line VDL1, thereby preventing differences in capacitance among the second capacitors C2 of the respective light emitting pixel drivers EPD.

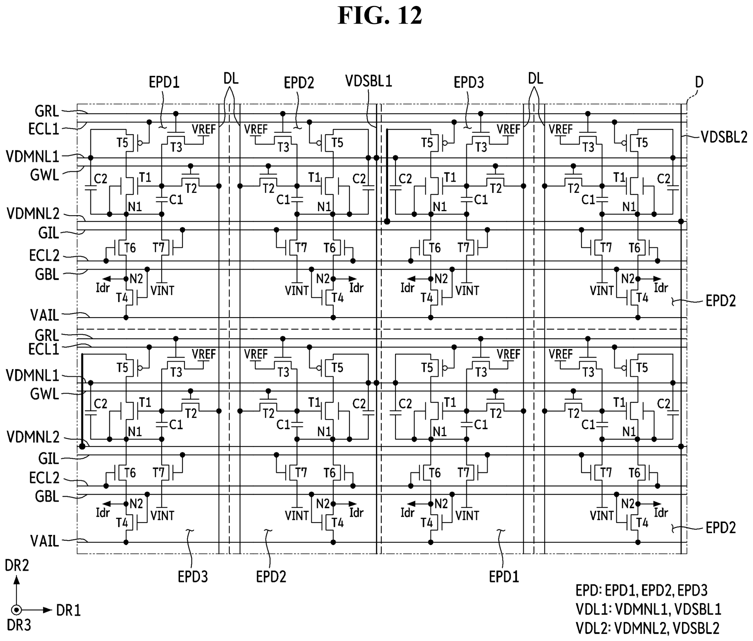

FIG. 12 is a schematic view showing the circuit layer of part D of FIG. 5 according to an embodiment.

Referring to FIG. 12, the circuit layer 120 of the display device 100 according to an embodiment includes the light emitting pixel drivers EPD arranged in the first direction DR1 and the second direction DR2. The circuit layer 120 may include a first power main line VDMNL1 extending in the first direction DR1 and transmitting the first power ELVDD1 (see FIGS. 10 and 11) to the light emitting pixel drivers EPD. The circuit layer 120 may include a second power main line VDMNL2 extending in the first direction DR1 and transmitting the second power ELVDD2 (see FIG. 11), which is different from the first power ELVDD1, to some (e.g. as subset as, for example, the third light emitting pixel driver EPD3) of the light emitting pixel drivers. Accordingly, the light emitting element electrically connected to some (e.g. a subset as, for example, the third light emitting pixel drivers) of the light emitting pixel drivers may be driven by a driving current corresponding to the second power ELVDD2, thereby improving luminance and improving the display quality of the display device.

According to an embodiment, each of the light emitting pixel drivers EPD may intersect the first power main line VDMNL1 and the second power main line VDMNL2.

According to an embodiment, the circuit layer 120 may further include a first power sub-line VDSBL1 extending in the second direction DR2 and electrically connected to the first power main line VDMNL1.

Accordingly, the first power line VDL1 for transmitting the first power ELVDD1 may have a mesh structure including the first power main line VDMNL1 and the first power sub-line VDSBL1, so that the first power ELVDD1 may be relatively evenly transmitted to the light emitting pixel drivers EPD of the display area DA.

According to an embodiment, the circuit layer 120 may further include a second power sub-line VDSBL2 extending in the second direction DR2 and electrically connected to the second power main line VDMNL2.

That is, the second power line VDL2 for transmitting the second power ELVDD2 may have a mesh structure including the second power main line VDMNL2 and the second power sub-line VDSBL2, so that the second power ELVDD2 may be relatively evenly transmitted to the light emitting pixel drivers EPD of the display area DA.

As shown in FIG. 12, the first power main line VDMNL1 may be electrically connected to the light emitting pixel drivers EPD.

According to an embodiment, the second power main line VDMNL2 may be electrically connected to the third light emitting pixel driver EPD3 among the light emitting pixel drivers EPD.

That is, the fifth transistor T5 of the third light emitting pixel driver EPD3 may be electrically connected to the second power main line VDMNL2.

In addition, the fifth transistor T5 of the first light emitting pixel driver EPD1 and the fifth transistor T5 of the second light emitting pixel driver EPD2 may be electrically connected to the first power main line VDMNL1.

In addition, the second capacitor C2 of each of the light emitting pixel drivers EPD may be electrically connected to the first power main line VDMNL1.

According to an embodiment, in each of the light emitting pixel drivers EPD, the fifth transistor T5 may be a P-type MOSFET, and the first transistor T1, the second transistor T2, the third transistor T3, the fourth transistor T4, the sixth transistor T6, and the seventh transistor T7 may be N-type MOSFETs.

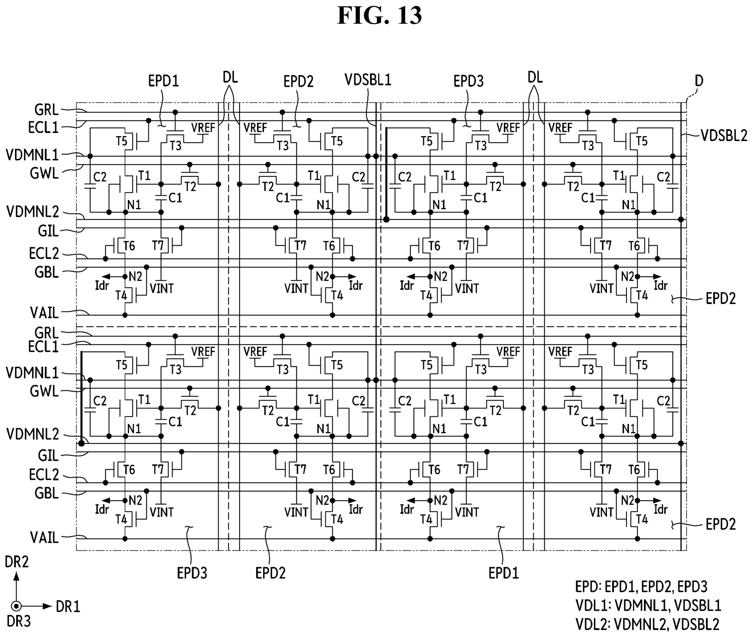

FIG. 13 is a schematic view showing the circuit layer of part D of FIG. 5 according to an embodiment.

As shown in FIG. 13, according to an embodiment, in each of the light emitting pixel drivers EPD, the first transistor T1, the second transistor T2, the third transistor T3, the fourth transistor T4, the fifth transistor T5, the sixth transistor T6, and the seventh transistor T7 may all be N-type MOSFETs.

The embodiment of FIG. 13 is substantially the same as the embodiment of FIG. 12, except that the fifth transistor T5 is an N-type MOSFET, and thus a redundant description thereof will be omitted below.

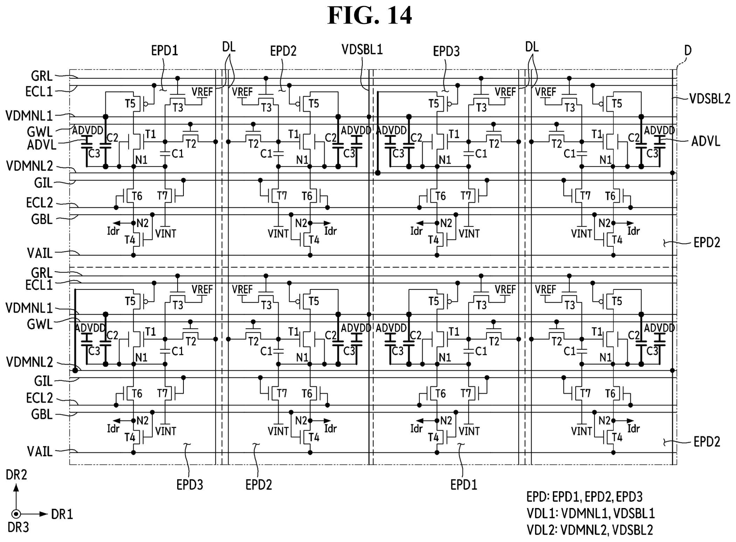

FIG. 14 is a schematic view showing the circuit layer of part D of FIG. 5 according to an embodiment.

As shown in FIG. 14, according to an embodiment, each of the light emitting pixel drivers EPD may further include a third capacitor C3 electrically connected between an additional power line ADVL for transmitting an additional power ADVDD and the first node N1.

The additional power line ADVL may transmit one of the first power ELVDD1, the second power ELVDD2, and a fourth power (e.g. third power). The fourth power (e.g. third power) may have a voltage level different from those of the first power ELVDD1 and the second power ELVDD2, and greater than the third power ELVSS (see FIG. 10 and FIG. 11).

That is, the additional power ADVDD may be the same as one of the first power ELVDD1 and the second power ELVDD2, or may be a separate fourth power ELVSS.

In this way, the voltage of the first capacitor C1 may be divided across the second capacitor C2 and the third capacitor C3, so that a potential difference between the gate electrode of the first transistor T1 and the second electrode of the first transistor T1 may be more stably maintained.

The embodiment of FIG. 14 is substantially the same as the embodiment of FIG. 12, except that the light emitting pixel drivers EPD further include the third capacitor C3, and thus a redundant description thereof will be omitted below.

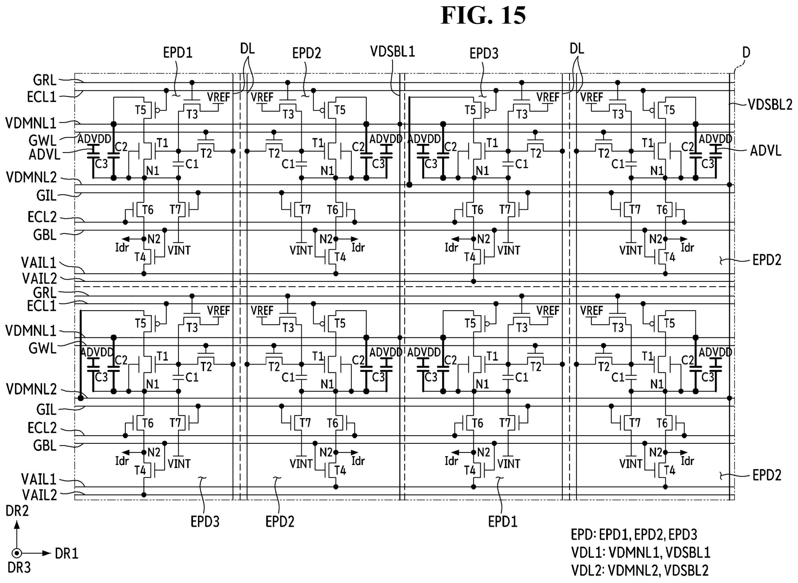

FIG. 15 is a schematic view showing the circuit layer of part D of FIG. 5 according to an embodiment.

As shown in FIG. 15, according to an embodiment, the circuit layer 120 may include a first initialization voltage line VAIL1 for transmitting a first initialization voltage, and a second initialization voltage line VAIL2 for transmitting a second initialization voltage. The first initialization voltage and the second initialization voltage may have different voltage levels.

As mentioned above, according to an embodiment, each of the first light emitting element LE1 and the second light emitting element LE2 may include a single light emitting stack ESTA (see FIG. 7), whereas the third light emitting element LE3 may include two or more light emitting stacks ESTA1 and ESTA2 (see FIG. 8).

Accordingly, a voltage level for initializing the third light emitting element LE3 may differ from a voltage level for initializing the first light emitting element LE1 and the second light emitting element LE2.

Therefore, as shown in FIG. 15, according to an embodiment, each of the fourth transistor T4 of the first light emitting pixel driver EPD1 and the fourth transistor T4 of the second light emitting pixel driver EPD2 may be electrically connected to the first initialization voltage line VAIL1, and the fourth transistor T4 of the third light emitting pixel driver EPD3 may be electrically connected to the second initialization voltage line VAIL2.

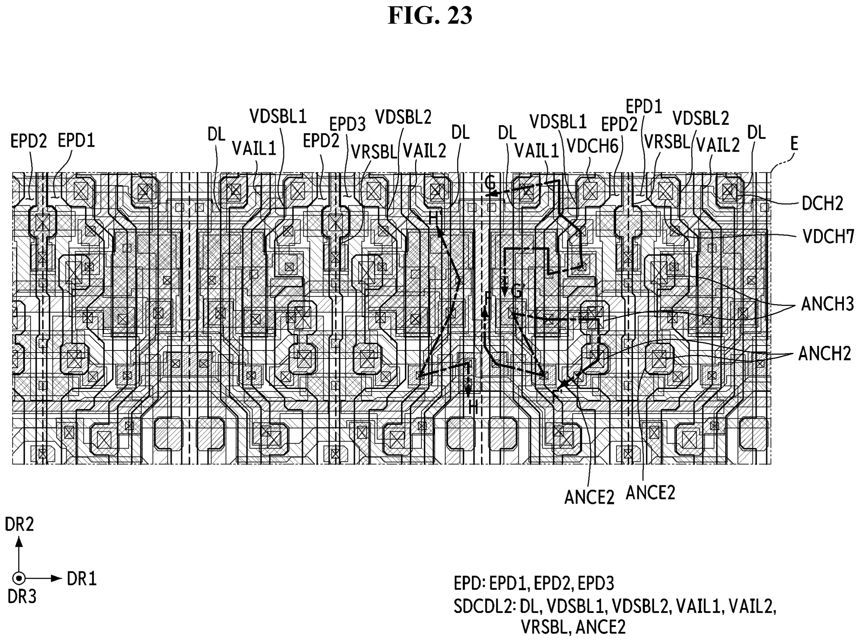

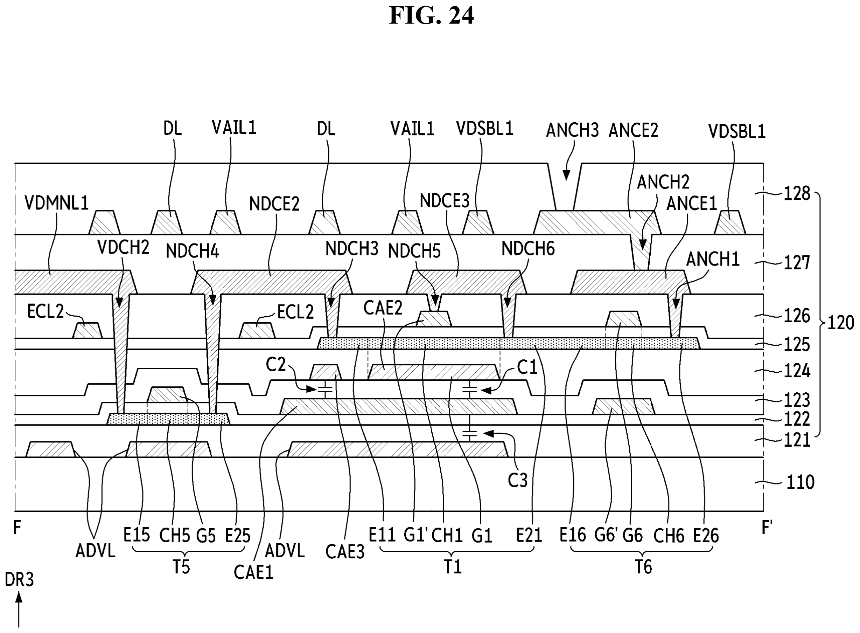

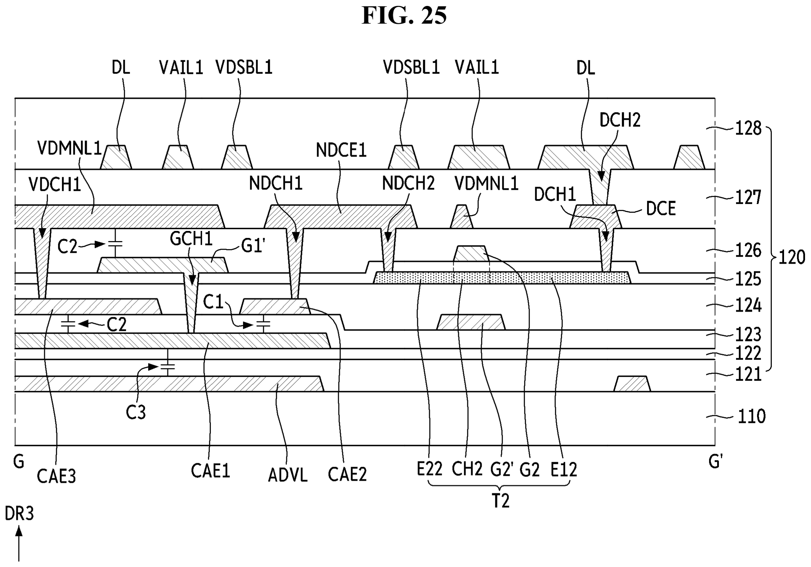

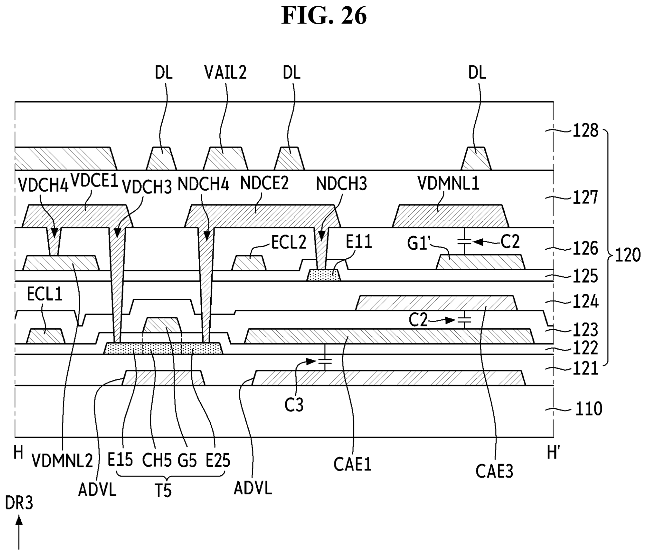

FIGS. 16, 17, 18, 19, 20, 21, 22, and 23 are plan views illustrating the circuit layer 120 of part E of FIG. 5 according to an embodiment of FIG. 15. FIG. 24 is a cross-sectional view taken along line F-F' of FIG. 23. FIG. 25 is a cross-sectional view taken along line G-G' of FIG. 23. FIG. 26 is a cross-sectional view taken along line H-H' of FIG. 23.

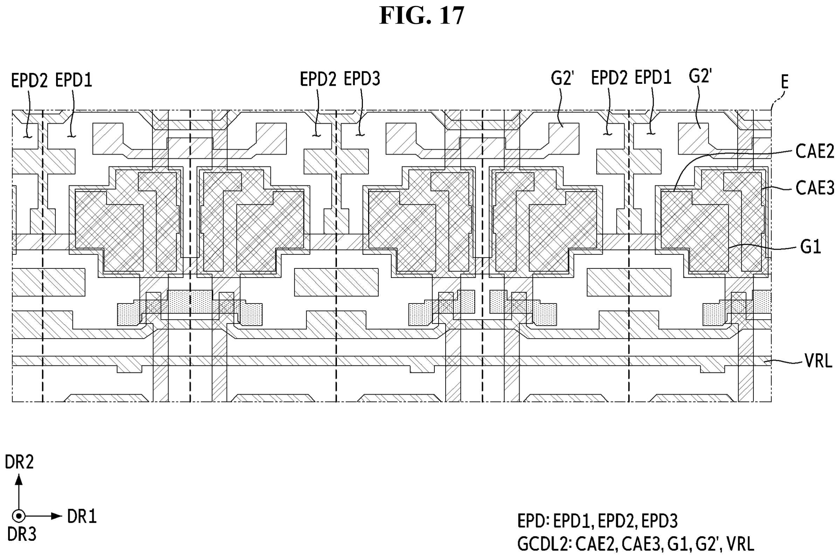

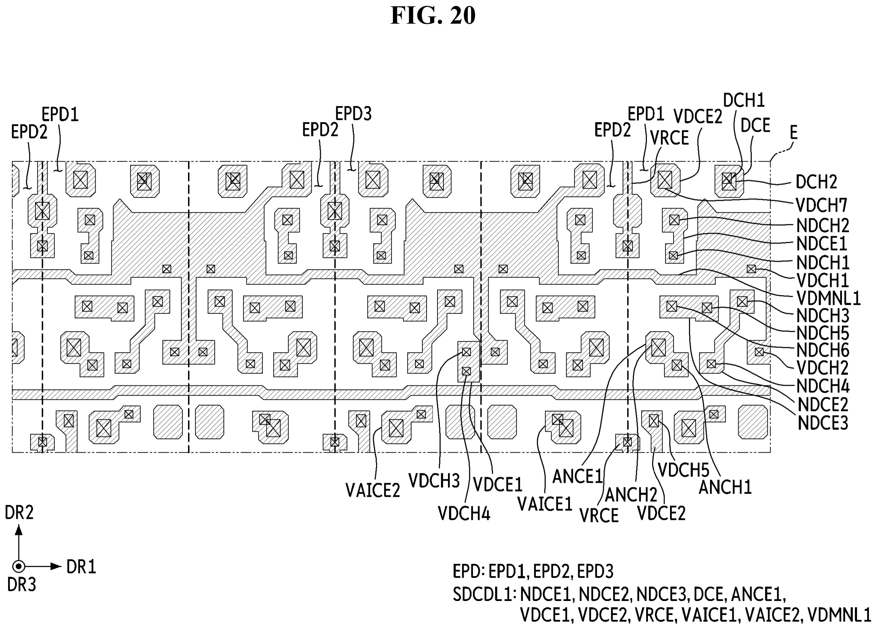

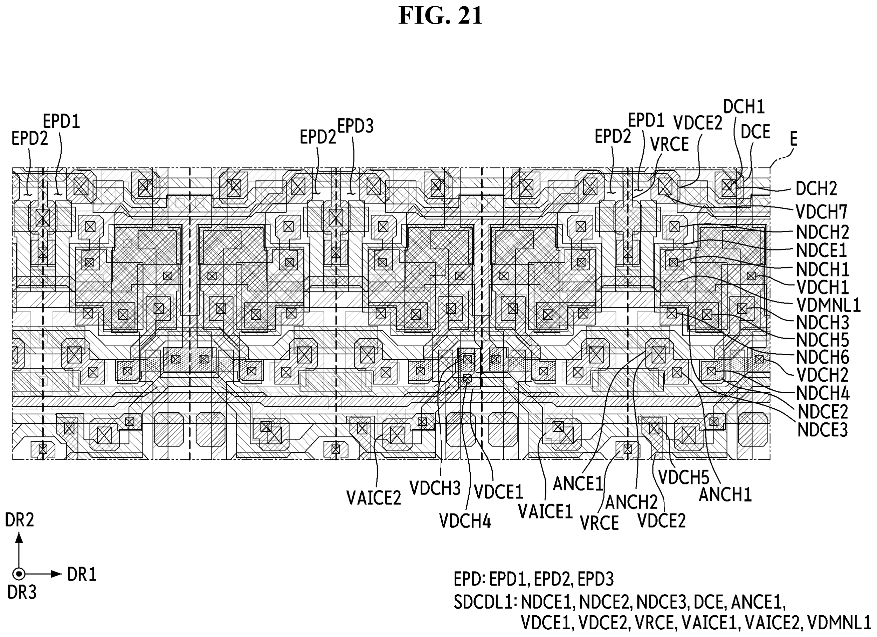

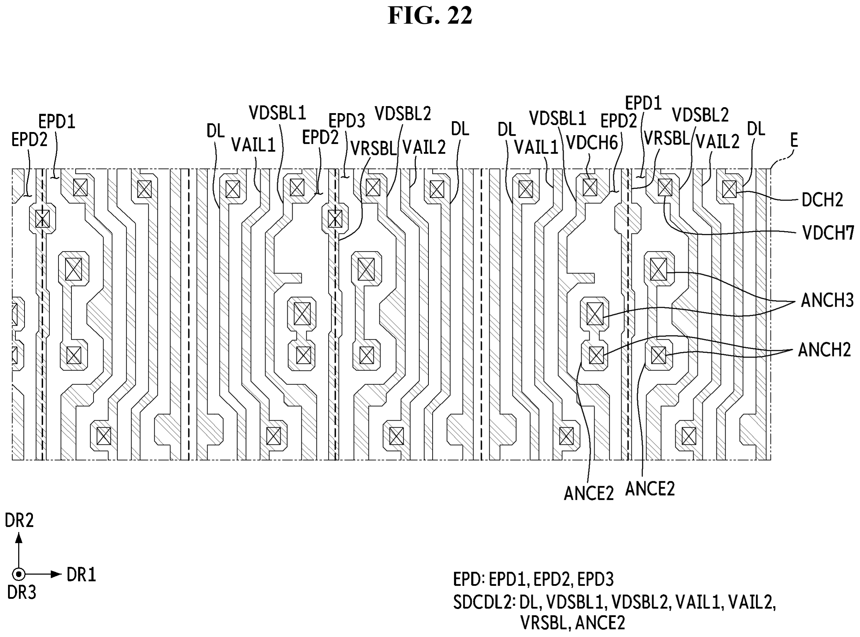

As shown in FIGS. 16, 17, 19, 21, 23, 24, 25, and 26, the circuit layer 120 of the display device 100 according to an embodiment may include the first semiconductor layer SEL1 (see FIG. 16) located on the substrate 110 (see FIGS. 24, 25, and 26), a first gate insulating layer 122 (see FIGS. 24, 25, and 26) covering the first semiconductor layer SEL1, a first gate conductive layer GCDL1 (see FIG. 16) located on the first gate insulating layer 122, a second gate insulating layer 123 (see FIGS. 24, 25, and 26) covering the first gate conductive layer GCDL1, a second gate conductive layer GCDL2 (see FIG. 17) located on the second gate insulating layer 123, a first interlayer insulating layer 124 (see FIGS. 24, 25, and 26) covering the second gate conductive layer GCDL2, the second semiconductor layer SEL2 (see FIGS. 18 and 19) located on the first interlayer insulating layer 124, a third gate insulating layer 125 (see FIGS. 24, 25, and 26) covering the second semiconductor layer SEL2, a third gate conductive layer GCDL3 (see FIGS. 18 and 19) located on the third gate insulating layer 125, a second interlayer insulating layer 126 (see FIGS. 24, 25, and 26) covering the third gate conductive layer GCDL3, a first source/drain conductive layer SDCDL1 (see FIGS. 20 and 21) located on the second interlayer insulating layer 126, a first planarization layer 127 (see FIGS. 24, 25, and 26) covering the first source/drain conductive layer SDCDL1, a second source/drain conductive layer SDCDL2 (see FIGS. 22 and 23) located on the first planarization layer 127, and a second planarization layer 128 (see FIGS. 24, 25, and 26) covering the second source/drain conductive layer SDCDL2.

According to an embodiment, as shown in FIGS. 18 and 19, a channel portion CH1, a first electrode E11, and a second electrode E21 of the first transistor T1 may be located in the second semiconductor layer SEL2.

According to an embodiment, as shown in FIG. 19, the first transistor T1 may include a main gate electrode G1 (see FIG. 17) that overlaps the channel portion CH1 of the first transistor T1 and is electrically connected to the second transistor T2 and the third transistor T3, and a sub-gate electrode G1' that overlaps the channel portion CH1 of the first transistor T1 and is electrically connected to the second electrode E21 of the first transistor T1.

As shown in FIG. 17, the main gate electrode G1 may be located in the second gate conductive layer GCDL2. The main gate electrode G1 may be connected to a second capacitor electrode CAE2.

As shown in FIGS. 18 and 19, the sub-gate electrode G1' may be located in the third gate conductive layer GCDL3.

As shown in FIGS. 20 and 21, the main gate electrode G1 (see FIG. 17) may be electrically connected to a second electrode E22 (see FIGS. 18 and 19) of the second transistor T2 and a second electrode E23 (see FIGS. 18 and 19) of the third transistor T3 through a first node connection electrode NDCE1.

The first node connection electrode NDCE1 may be electrically connected to the second capacitor electrode CAE2 (see FIG. 17) and the main gate electrode G1 (see FIG. 17) through a first node connection hole NDCH1, and may be electrically connected to the second electrode E22 (see FIGS. 18 and 19) of the second transistor T2 and the second electrode E23 (see FIGS. 18 and 19) of the third transistor T3 through a second node connection hole NDCH2.

The first electrode E11 (see FIGS. 18 and 19) of the first transistor T1 may be electrically connected to a second electrode E25 (see FIG. 16) of the fifth transistor T5 through a second node connection electrode NDCE2.

The second node connection electrode NDCE2 may be electrically connected to the first electrode E11 (see FIGS. 18 and 19) of the first transistor T1 through a third node connection hole NDCH3, and may be electrically connected to the second electrode E25 (see FIG. 16) of the fifth transistor T5 through a fourth node connection hole NDCH4.

The sub-gate electrode G1' may be electrically connected to the second electrode E21 (see FIGS. 18 and 19) of the first transistor T1 through a third node connection electrode NDCE3.

The third node connection electrode NDCE3 may be electrically connected to the sub-gate electrode G1' through a fifth node connection hole NDCH5, and may be electrically connected to the second electrode E21 (see FIGS. 18 and 19) of the first transistor T1 through a sixth node connection hole NDCH6.

According to an embodiment, as shown in FIG. 16, a channel portion CH5, a first electrode E15, and the second electrode E25 of the fifth transistor T5 may be located in the first semiconductor layer SEL1.

According to an embodiment, a gate electrode G5 of the fifth transistor T5 and the first emission control line ECL1 may be located in the first gate conductive layer GCDL1.

A portion of the first emission control line ECL1 overlapping the channel portion CH5 of the fifth transistor T5 may be the gate electrode G5 of the fifth transistor T5.

The first emission control line ECL1 may extend in the first direction DR1.

According to an embodiment, the reset control line GRL may be located in the first gate conductive layer GCDL1 and may extend in the first direction DR1.

A sub-gate electrode G3' of the third transistor T3 may be located in the first gate conductive layer GCDL1 and connected to the reset control line GRL.

A sub-gate electrode G6' of the sixth transistor T6 may be formed in an island shape in the first gate conductive layer GCDL1.

According to an embodiment, the circuit layer 120 may further include an initialization voltage sub-line VAISBL located in the first gate conductive layer GCDL1 and extending in the first direction DR1. The initialization voltage sub-line VAISBL may be electrically connected to one of the first initialization voltage line VAIL1 (see FIG. 15) and the second initialization voltage line VAIL2 (see FIG. 15).

For example, one of two initialization voltage sub-lines VAISBL adjacent in the second direction DR2 may be electrically connected to the first initialization voltage line VAIL1 (see FIG. 15), and the other thereof may be electrically connected to the second initialization voltage line VAIL2 (see FIG. 15).

According to an embodiment, each of the light emitting pixel drivers EPD may include a first capacitor electrode CAE1 formed in an island shape in the first gate conductive layer GCDL1.

As shown in FIGS. 18 and 19, the first capacitor electrode CAE1 may be electrically connected to the sub-gate electrode G1' of the first transistor T1 through a first gate connection hole GCH1.

As shown in FIGS. 20 and 21, the sub-gate electrode G1' of the first transistor T1 may be electrically connected to the second electrode E21 (see FIGS. 18 and 19) of the first transistor T1 through the third node connection electrode NDCE3.

Accordingly, the first capacitor electrode CAE1 may be electrically connected to the second electrode E21 (see FIGS. 18 and 19) of the first transistor T1 and the sub-gate electrode G1' (see FIGS. 18 and 19) of the first transistor T1.

As shown in FIG. 16, according to an embodiment, the circuit layer 120 may further include a light blocking conductive layer BCDL located on the substrate 110 (see FIGS. 24, 25, and 26).

The additional power line ADVL for transmitting the additional power ADVDD (see FIG. 15) may be located in the light blocking conductive layer BCDL.

As shown in FIGS. 16, 24, 25, and 26, the third capacitor C3 may be formed by a region where the first capacitor electrode CAE1 and the additional power line ADVL overlap in the third direction DR3.

As shown in FIG. 17, each of the light emitting pixel drivers EPD may include the second capacitor electrode CAE2 and a third capacitor electrode CAE3 located in the second gate conductive layer GCDL2.

The main gate electrode G1 of the first transistor T1 may be located in the second gate conductive layer GCDL2 and may be connected to the second capacitor electrode CAE2.

That is, a portion of the second capacitor electrode CAE2 overlapping the channel portion CH1 (see FIGS. 18 and 19) of the first transistor T1 may be the main gate electrode G1 of the first transistor T1.

As shown in FIGS. 20 and 21, the second capacitor electrode CAE2 may be electrically connected to the second electrode E22 (see FIGS. 18 and 19) of the second transistor T2 and the second electrode E23 (see FIGS. 18 and 19) of the third transistor T3 through the first node connection electrode NDCE1.

Thus, as shown in FIGS. 24 and 25, the first capacitor C1 may be formed by a region where the first capacitor electrode CAE1 and the second capacitor electrode CAE2 overlap each other.

As shown in FIG. 17, the third capacitor electrode CAE3 is spaced apart from the second capacitor electrode CAE2.

As shown in FIGS. 20 and 21, the third capacitor electrode CAE3 may be electrically connected to the first power main line VDMNL1 through a first power connection hole VDCH1.

Thus, as shown in FIGS. 24, 25, and 26, the second capacitor C2 may be formed by a region where the first capacitor electrode CAE1 and the third capacitor electrode CAE3 overlap each other.

As shown in FIG. 17, a sub-gate electrode G2' of the second transistor T2 may be formed in an island shape in the second gate conductive layer GCDL2.

The reference voltage line VRL may be located in the second gate conductive layer GCDL2 and may extend in the first direction DR1.

As shown in FIGS. 18 and 19, channel portions CH1, CH2, CH3, CH4, and CH6, first electrodes E11, E12, E13, E14, and E16, and second electrodes E21, E22, E23, E24, and E26 of the first transistor T1, the second transistor T2, the third transistor T3, the fourth transistor T4, and the sixth transistor T6 may be located in the second semiconductor layer SEL2.

The second electrode E21 of the first transistor T1 may be connected to the first electrode E16 of the sixth transistor T6.

The second electrode E22 of the second transistor T2 may be connected to the second electrode E23 of the third transistor T3.

The second electrode E26 of the sixth transistor T6 may be connected to the second electrode E24 of the fourth transistor T4.

The sub-gate electrode G1' of the first transistor T1, a gate electrode G2 of the second transistor T2, a gate electrode G3 of the third transistor T3, a gate electrode G4 of the fourth transistor T4, and a gate electrode G6 of the sixth transistor T6 may be located in the third gate conductive layer GCDL3.

The sub-gate electrode G1' of the first transistor T1 may be electrically connected to the first capacitor electrode CAE1 (see FIG. 16) through the first gate connection hole GCH1.

The scan write line GWL may be located in the third gate conductive layer GCDL3 and may extend in the first direction DR1.

A portion of the scan write line GWL overlapping the channel portion CH2 of the second transistor T2 may be the gate electrode G2 of the second transistor T2.

The scan write line GWL may be electrically connected to the sub-gate electrode G2' (see FIG. 17) of the second transistor T2 through a second gate connection hole GCH2.

The gate electrode G3 of the third transistor T3 may be electrically connected to the sub-gate electrode G3' (see FIG. 16) of the third transistor T3 and the reset control line GRL (see FIG. 16) through a third gate connection hole GCH3.

The second emission control line ECL2 may be located in the third gate conductive layer GCDL3 and may extend in the first direction DR1.

A portion of the second emission control line ECL2 that overlaps the channel portion CH6 of the sixth transistor T6 may be the gate electrode G6 of the sixth transistor T6.

The second emission control line ECL2 may be electrically connected to the sub-gate electrode G6' (see FIG. 16) of the sixth transistor T6 through a fourth gate connection hole GCH4.

The second power main line VDMNL2 may be located in the third gate conductive layer GCDL3 and may extend in the first direction DR1.

As shown in FIGS. 20 and 21, according to an embodiment, the circuit layer 120 may include the first node connection electrode NDCE1, the second node connection electrode NDCE2, the third node connection electrode NDCE3, a data connection electrode DCE, a first anode connection electrode ANCE1, a first power connection electrode VDCE1, a second power connection electrode VDCE2, a reference voltage connection electrode VRCE, a first initialization voltage connection electrode VAICE1, a second initialization voltage connection electrode VAICE2, and the first power main line VDMNL1, which are located in the first source/drain conductive layer SDCDL1.

The first node connection electrode NDCE1 may be electrically connected to the second capacitor electrode CAE2 (see FIG. 17) and the main gate electrode G1 (see FIG. 17) through the first node connection hole NDCH1, and may be electrically connected to the second electrode E22 (see FIGS. 18 and 19) of the second transistor T2 and the second electrode E23 (see FIGS. 18 and 19) of the third transistor T3 through the second node connection hole NDCH2.

The second node connection electrode NDCE2 may be electrically connected to the first electrode E11 (see FIGS. 18 and 19) of the first transistor T1 through the third node connection hole NDCH3, and may be electrically connected to the second electrode E25 (see FIG. 16) of the fifth transistor T5 through the fourth node connection hole NDCH4.

The third node connection electrode NDCE3 may be electrically connected to the sub-gate electrode G1' through the fifth node connection hole NDCH5, and may be electrically connected to the second electrode E21 (see FIGS. 18 and 19) of the first transistor T1 through the sixth node connection hole NDCH6.

The data connection electrode DCE may be electrically connected to the first electrode E12 (see FIGS. 18 and 19) of the second transistor T2 through a first data connection hole DCH1.

The first anode connection electrode ANCE1 may be electrically connected to the second electrode E24 (see FIGS. 18 and 19) of the fourth transistor T4 and the second electrode E26 (see FIGS. 18 and 19) of the sixth transistor T6 through a first anode connection hole ANCH1.

The first power main line VDMNL1 may extend in the first direction DR1.

The first power main line VDMNL1 may be electrically connected to the third capacitor electrode CAE3 (see FIG. 17) through the first power connection hole VDCH1.

A portion of the first power main line VDMNL1 may overlap the sub-gate electrode G1' (see FIGS. 18 and 19) of the first transistor T1.

The sub-gate electrode G1' of the first transistor T1 (see FIGS. 18 and 19) is electrically connected to the second electrode E21 (see FIGS. 18 and 19) of the first transistor T1 through the third node connection electrode NDCE3.

Therefore, as shown in FIGS. 25 and 26, the second capacitor C2 may further be formed by a region where the sub-gate electrode G1' of the first transistor T1 (see FIGS. 18 and 19) and the first power main line VDMNL1 overlap in the third direction DR3.

As shown in FIGS. 20 and 21, the first power main line VDMNL1 may be electrically connected to the first electrode E15 (see FIG. 16) of the fifth transistor T5 of the first light emitting pixel driver EPD1 and the first electrode E15 (see FIG. 16) of the fifth transistor T5 of the second light emitting pixel driver EPD2 through a second power connection hole VDCH2.

The first power connection electrode VDCE1 may be electrically connected to the first electrode E15 (see FIG. 16) of the fifth transistor T5 of the third light emitting pixel driver EPD3 through a third power connection hole VDCH3, and may be electrically connected to the second power main line VDMNL2 (see FIGS. 18 and 19) through a fourth power connection hole VDCH4.

That is, the first electrode E15 (see FIG. 16) of the fifth transistor T5 of the third light emitting pixel driver EPD3 may be electrically connected to the second power main line VDMNL2 (see FIGS. 18 and 19) through the first power connection electrode VDCE1.

The second power connection electrode VDCE2 may be electrically connected to the second power main line VDMNL2 (see FIGS. 18 and 19) through a fifth power connection hole VDCH5.

The reference voltage connection electrode VRCE may be electrically connected to the reference voltage line VRL (see FIG. 17) and the first electrode E13 (see FIGS. 18 and 19) of the third transistor T3.

The first initialization voltage connection electrode VAICE1 may be electrically connected to the first electrode E14 (see FIGS. 18 and 19) of the fourth transistor T4 of the first light emitting pixel driver EPD1, and the first electrode E14 (see FIGS. 18 and 19) of the fourth transistor T4 of the second light emitting pixel driver EPD2.

The second initialization voltage connection electrode VAICE2 may be electrically connected to the first electrode E14 (see FIGS. 18 and 19) of the fourth transistor T4 of the third light emitting pixel driver EPD3.

As shown in FIGS. 22 and 23, according to an embodiment, the circuit layer 120 may include the data line DL, the first power sub-line VDSBL1, the second power sub-line VDSBL2, the first initialization voltage line VAIL1, the second initialization voltage line VAIL2, a reference voltage sub-line VRSBL, and a second anode connection electrode ANCE2, which are located in the second source/drain conductive layer SDCDL2.

Each of the data line DL, the first power sub-line VDSBL1, the second power sub-line VDSBL2, the first initialization voltage line VAIL1, the second initialization voltage line VAIL2, and the reference voltage sub-line VRSBL may extend in the second direction DR2.

The second anode connection electrode ANCE2 may be electrically connected to the first anode connection electrode ANCE1 (see FIGS. 20 and 21) through a second anode connection hole ANCH2.

The second anode connection electrode ANCE2 may be electrically connected to one of the light emitting elements LE (see FIG. 6) through a third anode connection hole ANCH3.

The data line DL may be electrically connected to the data connection electrode DCE (see FIGS. 20 and 21) through a second data connection hole DCH2.

Accordingly, the first electrode E12 (see FIGS. 18 and 19) of the second transistor T2 may be electrically connected to the data line DL through the data connection electrode DCE (see FIGS. 20 and 21).

The first power sub-line VDSBL1 may be electrically connected to the first power main line VDMNL1 (see FIGS. 20 and 21) through a sixth power connection hole VDCH6.

The second power sub-line VDSBL2 may be electrically connected to the second power connection electrode VDCE2 (see FIGS. 20 and 21) through a seventh power connection hole VDCH7.

Accordingly, the second power main line VDMNL2 (see FIGS. 18 and 19) may be electrically connected to the second power sub-line VDSBL2 through the second power connection electrode VDCE2 (see FIGS. 20 and 21).

The first initialization voltage line VAIL1 may be electrically connected to the first initialization voltage connection electrode VAICE1 (see FIGS. 20 and 21).

Accordingly, the first electrode E14 (see FIGS. 18 and 19) of the fourth transistor T4 of the first light emitting pixel driver EPD1 and the first electrode E14 (see FIGS. 18 and 19) of the fourth transistor T4 of the second light emitting pixel driver EPD2 may be electrically connected to the first initialization voltage line VAIL1 through the first initialization voltage connection electrode VAICE1 (see FIGS. 20 and 21).

The second initialization voltage line VAIL2 may be electrically connected to the second initialization voltage connection electrode VAICE2 (see FIGS. 20 and 21).

Accordingly, the first electrode E14 (see FIGS. 18 and 19) of the fourth transistor T4 of the third light emitting pixel driver EPD3 may be electrically connected to the second initialization voltage line VAIL2 through the second initialization voltage connection electrode VAICE2 (see FIGS. 20 and 21).

The reference voltage sub-line VRSBL may be electrically connected to the reference voltage connection electrode VRCE (see FIGS. 20 and 21).

Accordingly, the reference voltage line VRL (see FIG. 17) may be electrically connected to the reference voltage sub-line VRSBL through the reference voltage connection electrode VRCE (see FIGS. 20 and 21).

Therefore, the reference voltage VREF (see FIGS. 10 and 11) may be transmitted relatively evenly to the light emitting pixel drivers EPD of the display area DA through wiring in a mesh structure including the reference voltage line VRL (see FIG. 17) and the reference voltage sub-line VRSBL.

As shown in FIGS. 24 and 25, according to an embodiment, the circuit layer 120 may include the first semiconductor layer SEL1 (see FIG. 16) located on the substrate 110, the first gate insulating layer 122 covering the first semiconductor layer SEL1 (see FIG. 16), the first gate conductive layer GCDL1 (see FIG. 16) located on the first gate insulating layer 122, the second gate insulating layer 123 covering the first gate conductive layer GCDL1, the second gate conductive layer GCDL2 (see FIG. 17) located on the second gate insulating layer 123, the first interlayer insulating layer 124 covering the second gate conductive layer GCDL2, the second semiconductor layer SEL2 (see FIGS. 18 and 19) located on the first interlayer insulating layer 124, the third gate insulating layer 125 covering the second semiconductor layer SEL2, the third gate conductive layer GCDL3 (see FIGS. 18 and 19) located on the third gate insulating layer 125, the second interlayer insulating layer 126 covering the third gate conductive layer GCDL3, the first source/drain conductive layer SDCDL1 (see FIGS. 20 and 21) located on the second interlayer insulating layer 126, the first planarization layer 127 covering the first source/drain conductive layer SDCDL1, the second source/drain conductive layer SDCDL2 (see FIGS. 22 and 23) located on the first planarization layer 127, and the second planarization layer 128 covering the second source/drain conductive layer SDCDL2.

According to an embodiment, the circuit layer 120 may further include a buffer layer 121 covering the light blocking conductive layer BCDL (see FIG. 16) and the additional power line ADVL located in the light blocking conductive layer BCDL on the substrate 110.

The first semiconductor layer SEL1 (see FIG. 16) may be located on the buffer layer 121.

The channel portion CH5, the first electrode E15, and the second electrode E25 of the fifth transistor T5 may be located on the buffer layer 121.

The channel portion CH5 of the fifth transistor T5 may overlap the additional power line ADVL in the third direction DR3. By doing so, leakage current of the fifth transistor T5 caused by light passing through the substrate 110 may be reduced or prevented.

The gate electrode G5 of the fifth transistor T5 may be located on the first gate insulating layer 122, and may overlap the channel portion CH5 of the fifth transistor T5 in the third direction DR3.

The first capacitor electrode CAE1 and the sub-gate electrode G6' of the sixth transistor T6 may be located on the first gate insulating layer 122.

The additional power line ADVL may overlap the first capacitor electrode CAE1 in the third direction DR3.

The second capacitor electrode CAE2 and the third capacitor electrode CAE3 may be located on the second gate insulating layer 123 and may be spaced apart from each other.

The second capacitor electrode CAE2 and the third capacitor electrode CAE3 may overlap the first capacitor electrode CAE1 in the third direction DR3.

The main gate electrode G1 of the first transistor T1 may be located on the second gate insulating layer 123 and may be connected to the second capacitor electrode CAE2.

The channel portions CH1 and CH6, the first electrodes E11 and E16, and the second electrodes E21 and E26 of the first and sixth transistors T1 and T6 may be located on the first interlayer insulating layer 124.

The channel portion CH1 of the first transistor T1 may overlap the main gate electrode G1 of the first transistor T1 in the third direction DR3.

That is, a portion of the second capacitor electrode CAE2 may be the main gate electrode G1 of the first transistor T1 overlapping the channel portion CH1 of the first transistor T1 in the third direction DR3.

The channel portion CH6 of the sixth transistor T6 may overlap the sub-gate electrode G6' of the sixth transistor T6 in the third direction DR3.

As shown in FIG. 24, the second emission control line ECL2, the sub-gate electrode G1' of the first transistor T1, and the main gate electrode G6 of the sixth transistor T6 may be located on the third gate insulating layer 125.

The sub-gate electrode G1' of the first transistor T1 may overlap the channel portion CH1 of the first transistor T1 in the third direction DR3.

The main gate electrode G6 of the sixth transistor T6 may overlap the channel portion CH6 of the sixth transistor T6 in the third direction DR3.

For example, a portion of the second emission control line ECL2 may be the main gate electrode G6 of the sixth transistor T6 overlapping the channel portion CH6 of the sixth transistor T6.

The first power main line VDMNL1, the second node connection electrode NDCE2, the third node connection electrode NDCE3, and the first anode connection electrode ANCE1 may be located on the second interlayer insulating layer 126.

The first power main line VDMNL1 may be electrically connected to the first electrode E15 of the fifth transistor T5 of each of the first light emitting pixel driver EPD1 (see FIG. 23) and the second light emitting pixel driver EPD2 (see FIG. 23) through the second power connection hole VDCH2.

The second node connection electrode NDCE2 may be electrically connected to the first electrode E11 of the first transistor T1 through the third node connection hole NDCH3, and may be electrically connected to the second electrode E25 of the fifth transistor T5 through the fourth node connection hole NDCH4.

Accordingly, the first electrode E11 of the first transistor T1 may be electrically connected to the second electrode E25 of the fifth transistor T5 through the second node connection electrode NDCE2.

The third node connection electrode NDCE3 may be electrically connected to the sub-gate electrode G1' through the fifth node connection hole NDCH5, and may be electrically connected to the second electrode E21 of the first transistor T1 through the sixth node connection hole NDCH6.

The first electrode E16 of the sixth transistor T6 may be connected to the second electrode E21 of the first transistor T1.

The first anode connection electrode ANCE1 may be electrically connected to the second electrode E26 of the sixth transistor T6 through the first anode connection hole ANCH1.

The data line DL, the second anode connection electrode ANCE2, the first initialization voltage line VAIL1, and the first power sub-line VDSBL1 may be located on the first planarization layer 127.

The second anode connection electrode ANCE2 may be electrically connected to the first anode connection electrode ANCE1 through a second anode connection hole ANCH2.

For electrical connection between the second anode connection electrode ANCE2 and the anode electrode 131 (see FIG. 6), the third anode connection hole ANCH3 overlapping a portion of the second anode connection electrode ANCE2 may be formed.

As shown in FIG. 25, the sub-gate electrode G2' of the second transistor T2 may be located on the second gate insulating layer 123.

The channel portion CH2, the first electrode E12, and the second electrode E22 of the second transistor T2 may be located on the first interlayer insulating layer 124.

The gate electrode G2 of the second transistor T2 may be located on the third gate insulating layer 125.

The channel portion CH2 of the second transistor T2 may overlap the sub-gate electrode G2' of the second transistor T2 and the gate electrode G2 of the second transistor T2 in the third direction DR3.

The first node connection electrode NDCE1 and the data connection electrode DCE may be located on the second interlayer insulating layer 126.

The first node connection electrode NDCE1 may be electrically connected to the second capacitor electrode CAE2 through the first node connection hole NDCH1, and may be electrically connected to the second electrode E22 of the second transistor T2 through the second node connection hole NDCH2.

The data connection electrode DCE may be electrically connected to the first electrode E12 of the second transistor T2 through the first data connection hole DCH1.

The data line DL may be located on the first planarization layer 127 and may be electrically connected to the data connection electrode DCE through the second data connection hole DCH2.

As shown in FIG. 25, the sub-gate electrode G1' of the first transistor T1 may be electrically connected to the first capacitor electrode CAE1 through the first gate connection hole GCH1.

As shown in FIG. 24, the sub-gate electrode G1' of the first transistor T1 may be electrically connected to the second electrode E21 of the first transistor T1 through the third node connection electrode NDCE3.

As shown in FIGS. 17 and 24, the second capacitor electrode CAE2 is connected to the main gate electrode G1 of the first transistor T1.

As shown in FIG. 25, the second capacitor electrode CAE2 may be electrically connected to the second electrode E22 of the second transistor T2 through the first node connection electrode NDCE1.

The third capacitor electrode CAE3 may be electrically connected to the first power main line VDMNL1 through the first power connection hole VDCH1.

Accordingly, as shown in FIGS. 24 and 25, the first capacitor C1 may be formed by a region where the first capacitor electrode CAE1 and the second capacitor electrode CAE2 overlap in the third direction DR3.

The second capacitor C2 may be formed by a region where the first capacitor electrode CAE1 and the third capacitor electrode CAE3 overlap in the third direction DR3.

In addition, the second capacitor C2 may be formed by a region where the sub-gate electrode G1' of the first transistor T1 and the first power main line VDMNL1 overlap in the third direction DR3.

The third capacitor C3 may be formed by a region where the first capacitor electrode CAE1 and the additional power line ADVL overlap in the third direction DR3.

As shown in FIG. 26, the second power main line VDMNL2 may be located on the third gate insulating layer 125.

The first power connection electrode VDCE1 may be located on the second interlayer insulating layer 126.

The second initialization voltage line VAIL2 may be located on the first planarization layer 127.

The first electrode E15 of the fifth transistor T5 of the third light emitting pixel driver EPD3 may be electrically connected to the second power main line VDMNL2 through the first power connection electrode VDCE1.

The display device 100 of each embodiment as described above may be applied to various electronic devices.

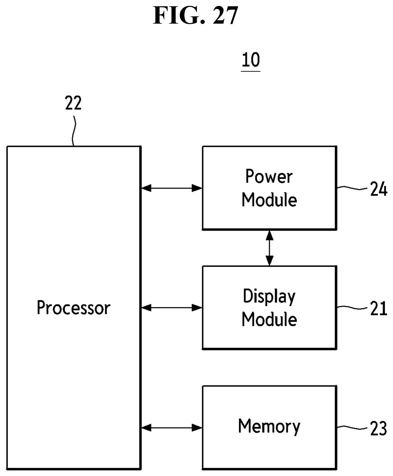

The electronic device 10 (see FIG. 27) according to an embodiment may include the above-described display device 100.

Additionally, the electronic device 10 (see FIG. 27) according to an embodiment may further include a module or device having other additional functions in addition to the display device 100.

FIG. 27 is a block diagram of an electronic device according to an embodiment.

Referring to FIG. 27, an electronic device 10 according to an embodiment may include a display module 21, a processor 22, a memory 23, and a power module 24.

The display module 21 may include the display device 100 for displaying an image.

The processor 22 be one or more processors and may may include at least one of a central processing unit (CPU), an application processor (AP), a graphic processing unit (GPU), a communication processor (CP), an image signal processor (ISP), or a controller.

The memory 23 may store data information required for the operation of the processor 22 or the display module 21. When the processor 22 executes an application stored in the memory 23, an image data signal and/or an input control signal is transmitted to the display module 21, and the display module 21 may process the received signal and output image information through a display screen.

The power module 24 may include a power supply module, such as a power adapter or a battery device, and a power conversion module that converts the power supplied by the power supply module to generate the power required for the operation of the electronic device 10.

At least one of the components of the electronic device 10 described above may be included in the display device according to the embodiments described above. Further, some of individual modules functionally included in one module may be included in the display device and some others may be provided separately from the display device. For example, the display device may include the display module 21, and the processor 22, the memory 23, and the power module 24 may be provided in the form of other devices in the electronic device 10 other than the display device.

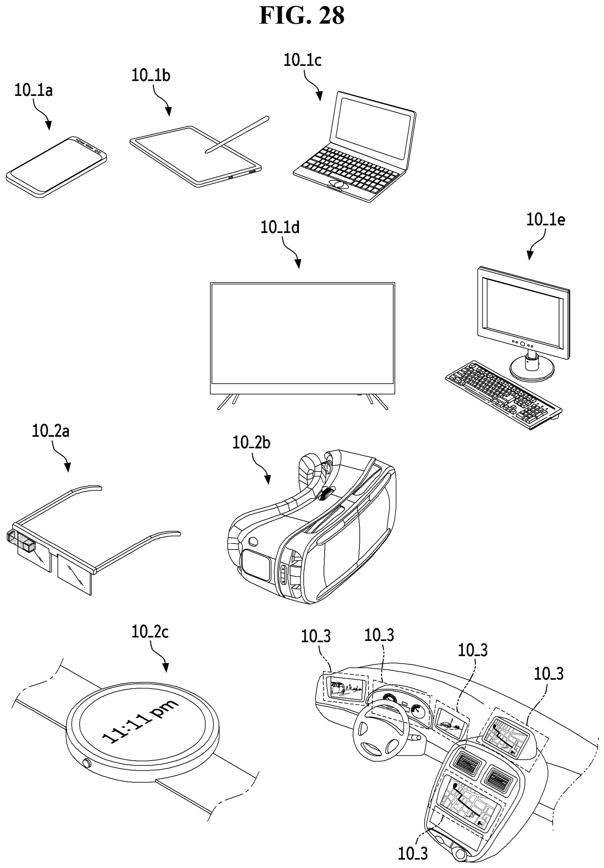

FIG. 28 is schematic views of electronic devices according to various embodiments.

Referring to FIG. 28, the electronic devices 10 (see FIG. 27) according to the embodiments may include not only an image display electronic device such as a smartphone 10_1a, a tablet PC 10_1b, a laptop 10_1c, a TV 10_1d, and a desk monitor 10_1e, but also a wearable electronic device such as smart glasses 10_2a, a head mounted display 10_2b, and a smart watch 10_2c, and a vehicle electronic device 10_3 such as a dashboard of a vehicle, a center fascia, a center information display (CID) of the dashboard, and a room mirror display.

However, the effects of the present disclosure are not restricted to the one set forth herein. The above and other effects of the present disclosure will become more apparent to one of daily skill in the art to which the present disclosure pertains by referencing the claims.

## Claims

1. A display device (100) comprising:
a substrate (110) comprising a display area (DA) in which emission areas (EA) are arranged;
a circuit layer (120) located on the substrate (110); and
an element layer (130) located on the circuit layer (120),
wherein the element layer (130) comprises light emitting elements (LE) arranged in each of the emission areas (EA), and
the circuit layer (120) comprises:
light emitting pixel drivers (EPD) arranged in a first direction (DR1) and a second direction (DR2) and configured to transmit a driving current to the light emitting elements (LE);
a first power main line (VDMNL1) extending in the first direction (DR1) and configured to transmit a first power (ELVDD1) to the light emitting pixel drivers (EPC); and
a second power main line (VDMNL2) extending in the first direction (DR1) and configured to transmit a second power (ELVDD2) different from the first power (ELVDD1) to a subset of the light emitting pixel drivers (EPD).

2. The display device (100) of claim 1, wherein each of the light emitting pixel drivers (EPD) comprises:
a first transistor (T1) configured to generate the driving current;
a second transistor (T2) electrically connected between a data line (DL) for transmitting a data signal and a gate electrode of the first transistor (T1);
a third transistor (T3) electrically connected between a reference voltage line (VRL) that is configured to transmit a reference voltage (VREF) and the gate electrode of the first transistor (T1);
a first capacitor (C1) electrically connected between the gate electrode of the first transistor (T1) and a first node (N1);
a second capacitor (C2) electrically connected between the first power main line (VDMNL1) and the first node (N1);
a fourth transistor (TR4) electrically connected between an initialization voltage line (VAIL) that is configured to transmit an initialization voltage (VAINT) and a second node (N2);
a fifth transistor (T5) electrically connected to a first electrode of the first transistor (T1); and
a sixth transistor (T6) electrically connected between the first node (N1) and the second node (N2),
wherein the first node (N1) is electrically connected to a second electrode of the first transistor (T1),
the second node (N2) is electrically connected to one of the light emitting elements (LE).

3. The display device (100) of claim 2, wherein the fifth transistor (T5) of the first light emitting pixel driver (EPD1) and the fifth transistor (T5) of the second light emitting pixel driver (EPD2) are electrically connected to the first power main line (VDMNL1), and
the fifth transistor (T5) of the third light emitting pixel driver (EPD3) is electrically connected to the second power main line (VDMNL2).

4. The display device (100) of any one of the preceding claims 2 to 3, wherein the circuit layer (120) comprises:
a first semiconductor layer (SEL1) located on the substrate (110);
a first gate insulating layer (122) covering the first semiconductor layer (SEL1);
a first gate conductive layer (GCDL1) located on the first gate insulating layer (122);
a second gate insulating layer (123) covering the first gate conductive layer (GCDL1);
a second gate conductive layer (GCDL2) located on the second gate insulating layer (123);
a first interlayer insulating layer (124) covering the second gate conductive layer (GCDL1);
a second semiconductor layer (SEL2) located on the first interlayer insulating layer (124);
a third gate insulating layer (125) covering the second semiconductor layer (127, 128);
a third gate conductive layer (GCDL3) located on the third gate insulating layer (125);
a second interlayer insulating layer (126) covering the third gate conductive layer (GCDL3);
a first source/drain conductive layer (SDCDL1) located on the second interlayer insulating layer (126);
a first planarization layer (127) covering the first source/drain conductive layer (SDCDL1);
a second source/drain conductive layer (SDCDL2) located on the first planarization layer (127); and
a second planarization layer (128) covering the second source/drain conductive layer (SDCDL2),
wherein a channel portion (CH1), the first electrode (E11), and the second electrode (E21) of the first transistor (T1) are located in the second semiconductor layer (SEL2), and
a channel portion (CH5), a first electrode (E11), and a second electrode (E21) of the fifth transistor (T5) are located in the first semiconductor layer (SEL1).

5. The display device (100) of claim 4, wherein the first transistor (T1) comprises:
a main gate electrode (G1) located in the second gate conductive layer (GCDL2), overlapping the channel portion (CH1) of the first transistor (T1), and electrically connected to the second transistor (T2) and the third transistor (T3); and
a sub-gate electrode (G1') located in the third gate conductive layer (GCDL3), overlapping the channel portion (CH1) of the first transistor (T1), and electrically connected to the second electrode (E21) of the first transistor (T1).

6. The display device (100) of claim 5, wherein each of the light emitting pixel drivers (EPD) comprises:
a first capacitor electrode (CAE1) located in the first gate conductive layer (GCDL1) and electrically connected to the second electrode of the first transistor (T1) and the sub-gate electrode (G1');
a second capacitor electrode (CAE2) located in the second gate conductive layer (GCDL2) and electrically connected to the main gate electrode (G1); and
a third capacitor electrode (CAE3) located in the second gate conductive layer (GCDL2), spaced apart from the second capacitor electrode (CAE2), and electrically connected to the first power main line (VDMNL1),
wherein the first capacitor (C1) is formed by a region where the first capacitor electrode (CAE1) and the second capacitor electrode (CAE2) overlap in a third direction (DR3), and
the second capacitor (C2) is formed by a region where the first capacitor electrode (CAE1) and the third capacitor electrode (CAE3) overlap in the third direction (DR3).

7. The display device (100) of claim 6, wherein,
the first power main line (VDMNL1) is located in the first source/drain conductive layer (SDCDL1), and
the second capacitor (C2) is further formed by a region where the sub-gate electrode (G1') of the first transistor (T1) and the first power main line (VDMNL1) overlap in the third direction (DR3).

8. The display device (100) of any one of the preceding claims 6 to 7, wherein each of the light emitting pixel drivers (LPD) further comprises a third capacitor (C3) electrically connected between an additional power line (ADVL) and the first node (N1),
the additional power line (ADVL) is configured to transmit an additional power (ADVDD) being one of the first power (ELVDD1), the second power (ELVDD2), and a third power (ELVSS),
wherein the third power (ELVSS) is different from the first power (ELVDD1) and the second power (ELVDD2).

9. The display device (100) of claim 8, wherein the circuit layer (120) further comprises:
a light blocking conductive layer (BCDL) located on the substrate (110); and
a buffer layer (121) covering the light blocking conductive layer (BCDL),
wherein the first semiconductor layer (SEL1) is located on the buffer layer (121),
the additional power line (ADVL) is located in the light blocking conductive layer (BCDL), and
the third capacitor (C3) is formed by a region where the first capacitor electrode (CAE1) and the additional power line (ADVL) overlap in the third direction (DR3).

10. The display device (100) of any one of the preceding claims 4 to 9, wherein the first power main line (VDMNL1) is located in the first source/drain conductive layer (SDCDL2),
the second power main line (VDMNL2) is located in the third gate conductive layer (GCDL3).

11. The display device (100) of any one of the preceding claims 4 to 10, wherein the circuit layer (120) further comprises:
a first power sub-line (VDSBL1) located in the second source/drain conductive layer (SDCDL2), extending in the second direction (DR2), and electrically connected to the first power main line (VDSBL1); and
a second power sub-line (VDSBL2) located in the second source/drain conductive layer (SDCDL2), extending in the second direction (DR2), and electrically connected to the second power main line (VDSBL2).

12. The display device (100) of any one of the preceding claims 1 to 11, wherein each of the light emitting pixel drivers (LPD) intersects the first power main line (VDSBL1) and the second power main line (VDSBL2).

13. The display device (100) of any one of the preceding claims 1 to 12, wherein the emission areas (EA) comprise a first emission area (EA1), a second emission area (EA2), and a third emission area (EA3) configured to emit light of different wavelength bands,
the light emitting pixel drivers (EPD) comprise:
a first light emitting pixel driver (EPD1) electrically connected to a light emitting element of the first emission area (EA1);
a second light emitting pixel driver (EPD2) electrically connected to a light emitting element of the second emission area (EA2); and
a third light emitting pixel driver (EPD3) electrically connected to a light emitting element of the third emission area (EA3).

14. The display device (100) of claim 13, wherein the first emission area (EA1) is configured to emit light of a first wavelength band,
the second emission area (EA2) is configured to emit light of a second wavelength band lower than the first wavelength band,
the third emission area (EA3) is configured to emit light of a third wavelength band lower than the second wavelength band,
each of the light emitting elements comprises an anode electrode (131) and a cathode electrode (132) opposing each other in a third direction (DR3), and an organic layer (133) located between the anode electrode (131) and the cathode electrode (132),
each of the organic layer (133) of the light emitting element (LE1) of the first emission area (EA1) and the organic layer (133) of the light emitting element (LE2) of the second emission area (EA2) comprises one light emitting stack (ESTA),
the organic layer (133) of the light emitting element (LE3) of the third emission area (EA3) comprises two or more light emitting stacks (ESTA1, ESTA2), and at least one carrier generation layer (CGL) located between the two or more light emitting stacks (ESTA1, ESTA2), and
each of the one light emitting stack (ESTA) and the two or more light emitting stacks (ESTA1, ESTA2) comprises a light emitting layer (EML) in which an electron-hole pair is converted into light.

15. An electronic device (10) comprising:
a display device (100) configured to display an image according to any of the preceding claims 1 to 14;
a memory (23) storing an application;
one or more processors (22) configured to execute the application and transmitting an image data signal and an input control signal to the display device (100); and
a power module (24) configured to transmit power to the display device (100).
